# FASCICULE DE BREVET EUROPEEN

(11) **EP 3 815 141 B1**
(45) Date de publication et mention de la délivrance du brevet: **24.05.2023**
(21) Numéro de dépôt: 19733789.2
(22) Date de dépôt: 27.06.2019
(51) Int. Cl.: H01L 27/15, H01L 33/50

(54) **DISPOSITIFS ÉMETTEURS, ÉCRAN D'AFFICHAGE ASSOCIÉ ET PROCÉDÉS DE FABRICATION D'UN DISPOSITIF ÉMETTEUR**
EMITTIERENDE VORRICHTUNGEN, ZUGEHÖRIGE ANZEIGETAFEL UND VERFAHREN ZUR HERSTELLUNG EINER EMITTIERENDEN VORRICHTUNG
EMITTING DEVICES, ASSOCIATED DISPLAY PANEL AND METHODS FOR PRODUCING AN EMITTING DEVICE

(30) Priorité: 28.06.2018 FR 1855855
(43) Date de publication de la demande: 05.05.2021
(60) Demande divisionnaire: 23166469.9
(73) Titulaire: Aledia, 38130 Echirolles (FR)
(72) Inventeur: CHANG, Ying-Lan, CUPERTINO, CA 95014 (US); SCARINGELLA, Sylvia, 38330 MONTBONNOT SAINT MARTIN (FR); ROBIN, Ivan-Christophe, 38000 GRENOBLE (FR); ABOULAICH, Abdelhay, 38000 GRENOBLE (FR)
(74) Mandataire: Lavoix
(86) Numéro de dépôt international: PCT/EP2019/067237
(87) Numéro de publication internationale: WO 2020/002544

(56) Documents cités:
- FR-A1- 3 031 238
- US-A1- 2012 032 142
- US-A1- 2017 250 316

## Description

### DOMAINE DE L'INVENTION

La présente invention concerne un dispositif émetteur. La présente invention concerne également un écran d'affichage comprenant un ensemble de tels dispositifs émetteurs et un procédé de fabrication d'un tel dispositif émetteur.

### CONTEXTE DE L'INVENTION

Les écrans d'affichage comprennent souvent un ensemble « d'éléments d'image », également appelés « pixels », lesquels sont chacun propre à émettre de la lumière, de sorte que l'image sur l'écran peut être commandée en activant ou en désactivant les pixels individuels. Dans les écrans couleur, chaque pixel comprend plusieurs sous-pixels, chaque sous-pixel étant configuré pour émettre une couleur spécifique, de sorte que la couleur émise par le pixel peut être modifiée en commandant quel(s) sous-pixel(s) est ou sont activés ou en modifiant le courant électrique appliqué à chaque sous-pixel afin de modifier l'intensité d'émission relative de chaque sous-pixel.

Les structures semi-conductrices telles que les diodes électroluminescentes (LED) sont couramment utilisées à des fins diverses, tel que l'éclairage, en raison de leur bonne efficacité potentielle en matière d'émission de lumière. Sous l'effet de cette efficacité élevée potentielle, les LED ont été suggérées pour la fabrication d'écrans d'affichage à haute efficacité.

Les structures LED prennent généralement la forme d'un empilement de couches semi-conductrices planes. La lumière est émise lorsqu'un courant électrique circule à travers l'empilement. Cependant, bien que certaines technologies et certains matériaux utilisés dans la fabrication de structures LED permettent une bonne efficacité d'émission sur une partie spécifique du spectre visible, par exemple dans la gamme bleue, les mêmes technologies conduisent généralement à des efficacités beaucoup plus faibles lorsqu'elles sont utilisées pour fabriquer une structure LED émettant sur une autre partie du spectre. La fabrication de pixels dans lesquels chaque sous-pixel présente une structure LED émettant dans une partie du spectre visible qui est différente de celle des autres sous-pixels est par conséquent difficile et peut notamment nécessiter l'utilisation de différents types de matériaux pour chaque sous-pixel.

Selon une manière permettant d'obtenir les sous-pixels, des convertisseurs de rayonnement sont placés sur la surface de la structure LED afin de convertir la lumière émise par la partie de la structure située sous le convertisseur en une lumière présentant une longueur d'onde différente de celle de la lumière émise à l'origine par la couche. Ainsi, des sous-pixels fonctionnels peuvent être obtenus en plaçant sur des zones spécifiques de la structure LED différents convertisseurs de rayonnement, de sorte qu'en alimentant sélectivement en courant électrique la zone sous chaque convertisseur distinct, la lumière émise par la ou les couches semi-conductrices est convertie en une lumière présentant une couleur spécifique.

Cependant, au cours de l'étape de placement, la position des convertisseurs de rayonnement est difficile à contrôler. Par exemple, si les convertisseurs de rayonnement sont des particules contenues dans des résines photosensibles et déposées par photolithographie, une partie de la lumière d'insolation est diffusée par les particules et peut finir par insoler une partie indésirable de la résine. Même en utilisant d'autres techniques, lorsque deux convertisseurs de rayonnement doivent être placés l'un à côté de l'autre, un mélange peut se produire et avoir pour conséquence que la couleur du sous-pixel soit différente de la couleur attendue. Ces effets sont d'autant plus forts que la période spatiale entre les pixels diminue.

Les documents US 2017/250316 A1 et FR 3 031 238 A1 décrivent un dispositif émetteur comprenant au moins deux émetteurs de lumière émettant des rayonnements différents, chaque émetteur étant composé d'une structure semi-conductrice et d'un convertisseur de rayonnement.

### RÉSUMÉ DE L'INVENTION

En conséquence, il existe un besoin pour un dispositif émetteur, notamment un pixel, qui possède des sous-pixels de petites dimensions, tout en permettant un bon contrôle de la longueur d'onde de la lumière émise par chaque sous-pixel.

A cet effet, la présente description concerne un dispositif émetteur selon la revendication 1.

Selon les modes de réalisation spécifiques, le dispositif émetteur comprend une ou plusieurs des caractéristiques des revendications 2 à 6, prises séparément ou selon toute combinaison possible.

La présente description concerne également un procédé de fabrication selon la revendication 7.

Un écran d'affichage selon la revendication 8 est également proposé.

### BRÈVE DESCRIPTION DES DESSINS

Des caractéristiques et avantages de l'invention seront mis en évidence par la description suivante, donnée uniquement à titre d'exemple non limitatif, et faisant référence aux dessins annexés, dans lesquels :
- La figure 1 est une vue latérale partielle d'un premier exemple d'écran d'affichage comprenant un ensemble de dispositifs émetteurs comprenant des structures tridimensionnelles ;
- La figure 2 est une vue en coupe latérale de deux exemples de structures tridimensionnelles de la figure 1 ;
- La figure 3 est un ordinogramme illustrant les différentes étapes d'un exemple de procédé de fabrication d'un dispositif émetteur de la figure 1 ;
- La figure 4 est une vue latérale partielle de l'écran d'affichage de la figure 1 à la fin d'une étape spécifique du procédé de fabrication d'un dispositif émetteur de la figure 1 ;
- La figure 5 est une vue latérale partielle d'un deuxième exemple d'écran d'affichage comprenant un ensemble de dispositifs émetteurs comprenant des structures tridimensionnelles ;
- La figure 6 est une vue latérale partielle d'un troisième exemple d'écran d'affichage comprenant un ensemble de dispositifs émetteurs comprenant des structures tridimensionnelles ; et
- La figure 7 est une vue latérale partielle d'un quatrième exemple d'écran d'affichage comprenant un ensemble de dispositifs émetteurs comprenant des structures tridimensionnelles.

### DESCRIPTION DÉTAILLÉE DES MODES DE RÉALISATION PRÉFÉRÉS

Plusieurs exemples d'écrans d'affichage 10 sont décrits ci-dessous.

Chaque écran d'affichage 10 est, par exemple, intégré dans un dispositif électronique tel qu'un téléphone mobile, une tablette ou un ordinateur portable. Dans un autre mode de réalisation, l'écran d'affichage 10 est intégré dans un dispositif d'affichage dédié tel qu'un téléviseur ou un écran d'ordinateur de bureau.

Chaque écran d'affichage 10 est configuré pour afficher un ensemble d'images.

Chaque écran d'affichage 10 comprend un ensemble de dispositifs émetteurs 15 et un circuit de commande.

Chaque dispositif émetteur 15, également appelé « élément d'image », ou en abrégé « pixel » est configuré pour émettre au moins un rayonnement.

Par exemple, chaque pixel 15 est configuré pour émettre l'un d'un ensemble de rayonnements comprenant un premier rayonnement, un deuxième rayonnement et au moins un troisième rayonnement. Dans un mode de réalisation, chaque pixel 15 est configuré pour émettre l'un d'un ensemble de rayonnements comprenant un premier rayonnement, un deuxième rayonnement et deux troisièmes rayonnements. En particulier, chaque pixel 15 est configuré pour émettre chaque rayonnement d'un ensemble de rayonnements comprenant un premier rayonnement, un deuxième rayonnement et deux troisièmes rayonnements.

Il est à noter que chaque dispositif émetteur 15 peut être utilisé en tant qu'une source de lumière unique à l'extérieur d'un écran d'affichage.

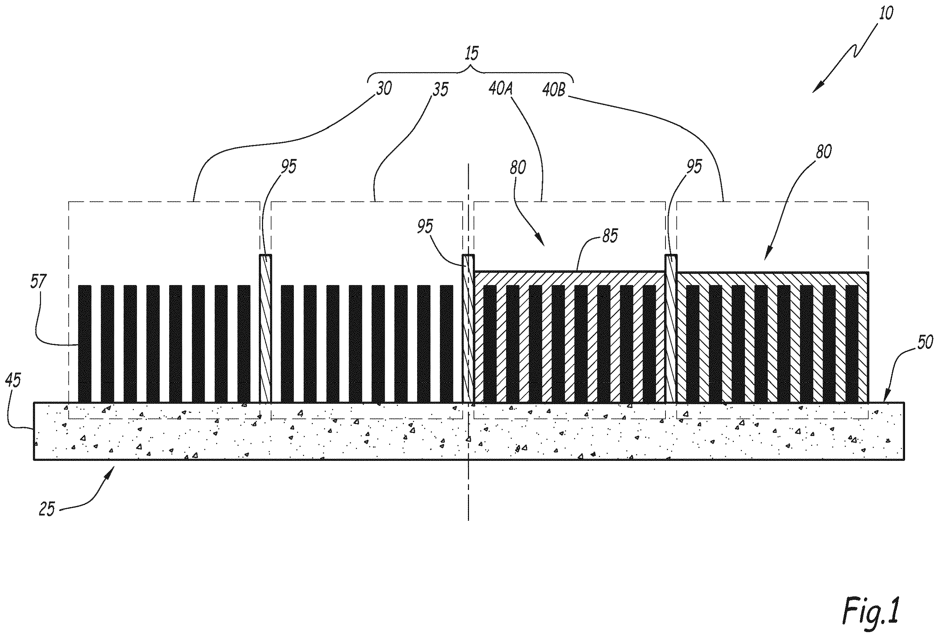

Tel que montré dans la figure 1, chaque dispositif émetteur 15 comprend un substrat 25 et un ensemble d'émetteurs de lumière 30, 35, 40A, 40B.

En particulier, dans tous les modes de réalisation décrits ci-dessous, le dispositif émetteur 15 peut comprendre au moins un premier émetteur de lumière 30 et/ou au moins un deuxième émetteur de lumière 35 et/ou au moins un troisième émetteur de lumière 40A, 40B.

Comme on le verra ci-dessous, les expressions « premier émetteur de lumière » 30, « deuxième émetteur de lumière » 35 et « troisième émetteur de lumière » 40A, 40B font chacune référence à différents types d'émetteurs de lumière 30, 35, 40A, 40B.

Chaque type d'émetteur de lumière 30, 35, 40A, 40B peut différer des autres types d'émetteurs de lumière 30, 35, 40A, 40B par la longueur d'onde du ou des rayonnements associés, ou par sa structure. Notamment, le « premier émetteur de lumière » 30 et le « deuxième émetteur de lumière » 35 sont chacun dépourvus de convertisseur de rayonnement, tandis que chaque « troisième émetteur de lumière » 40A, 40B comprend un convertisseur de rayonnement 80. Les émetteurs de lumière 30, 35 qui sont dépourvus de convertisseur de rayonnement 80 sont parfois appelés émetteurs « de couleur naturelle » ou sous-pixels « de couleur naturelle », tandis que les émetteurs de lumière 40A, 40B qui comprennent un convertisseur de rayonnement 80 sont appelés « émetteurs convertis ».

Chaque rayonnement comprend un ensemble d'ondes électromagnétiques.

Chaque ensemble correspond à une gamme de longueurs d'onde. La gamme de longueurs d'onde correspond au groupe formé par toutes les longueurs d'onde de l'ensemble d'ondes électromagnétiques.

Le premier rayonnement comprend un premier ensemble d'ondes électromagnétiques.

Le premier ensemble d'ondes électromagnétiques correspond à une première gamme de longueurs d'onde.

Une première longueur d'onde moyenne est définie pour la première gamme de longueurs d'onde.

Une longueur d'onde moyenne égale à la moitié de la somme de la plus grande et de la plus petite longueur d'onde de la première gamme de longueurs d'onde est un exemple de première longueur d'onde moyenne.

Le premier rayonnement est, par exemple, un rayonnement bleu. Un premier rayonnement dont la première longueur d'onde moyenne est comprise entre 430 nanomètres (nm) et 490 nm est un exemple de rayonnement bleu.

Le deuxième rayonnement est différent du premier rayonnement.

Le deuxième rayonnement comprend un deuxième ensemble d'ondes électromagnétiques.

Le deuxième ensemble d'ondes électromagnétiques correspond à une deuxième gamme de longueurs d'onde.

Une deuxième longueur d'onde moyenne est définie pour la deuxième gamme de longueurs d'onde. Une longueur d'onde moyenne égale à la moitié de la somme de la plus grande et de la plus petite longueur d'onde de la deuxième gamme de longueurs d'onde est un exemple de deuxième longueur d'onde moyenne.

La deuxième longueur d'onde moyenne est, dans un mode de réalisation, différente de la première longueur d'onde moyenne.

Le deuxième rayonnement est, par exemple, un rayonnement vert. Un deuxième rayonnement dont la deuxième longueur d'onde moyenne est comprise entre 500 nm et 560 nm est un exemple de rayonnement vert.

Chaque troisième rayonnement est, par exemple, différent du premier rayonnement et du deuxième rayonnement.

Chaque troisième rayonnement comprend un troisième ensemble d'ondes électromagnétiques.

Chaque troisième ensemble d'ondes électromagnétiques correspond à une troisième gamme de longueurs d'onde.

Une troisième longueur d'onde moyenne est définie pour chaque troisième gamme de longueurs d'onde. Une longueur d'onde moyenne égale à la moitié de la somme de la plus grande et de la plus petite longueur d'onde de la troisième gamme de longueurs d'onde est un exemple de troisième longueur d'onde moyenne.

La troisième longueur d'onde moyenne est, par exemple, strictement supérieure à au moins l'une parmi la première longueur d'onde moyenne et la deuxième longueur d'onde moyenne.

Dans un mode de réalisation, la troisième longueur d'onde moyenne est strictement supérieure à la première longueur d'onde moyenne et à la deuxième longueur d'onde moyenne.

L'un des troisièmes rayonnements est, par exemple, un rayonnement rouge. Par exemple, la troisième longueur d'onde moyenne correspondante est, par exemple, comprise entre 580 nm et 700 nm.

Lorsque le dispositif émetteur 15 est apte à émettre deux troisièmes rayonnements, l'autre troisième rayonnement est, par exemple, un rayonnement blanc ou un rayonnement jaune.

Un exemple de troisième rayonnement blanc est un troisième rayonnement comprenant l'un ou l'autre parmi :
- au moins un rayonnement bleu, au moins un rayonnement vert et au moins un rayonnement rouge ; ou
- au moins un rayonnement bleu et au moins un rayonnement jaune.

Un rayonnement dont la longueur d'onde moyenne est comprise entre 560 nm et 580 nm est un exemple de rayonnement jaune.

Le substrat 25 est configuré pour supporter chaque émetteur de lumière 30, 35, 40A et 40 B.

Le substrat 25 est, par exemple, commun à tous les émetteurs de lumière 30, 35, 40A et 40B.

Le substrat 25 est, par exemple, plan. Un substrat plan est un substrat 25 présentant une face de support plane 50.

Une direction normale D est définie pour le substrat 25. La face de support 50 du substrat 25 est perpendiculaire à la direction normale D.

Le substrat 25 est constitué d'un matériau semi-conducteur de substrat. Une valeur de bande interdite du substrat est définie pour le matériau semi-conducteur de substrat.

Selon un mode de réalisation, le matériau de substrat est le silicium. Dans d'autres modes de réalisation possibles, le matériau semi-conducteur de substrat est un autre matériau semi-conducteur tel que le carbure de silicium.

Dans un mode de réalisation, le matériau semi-conducteur de substrat est, par exemple, un nitrure d'élément III. Les nitrures d'éléments III sont un groupe de matériaux comprenant GaN, AIN et InN et les alliages de GaN, d'AIN et d'InN. Par exemple, le matériau semi-conducteur de substrat est le GaN.

Le matériau de substrat est, par exemple, dopé n. Cependant, le type de dopage peut varier dans certains modes de réalisation.

Dans un mode de réalisation, au moins une partie de la face de support 50 est recouverte d'un matériau électriquement isolant tel que SiOs ou SiN. Le matériau électriquement isolant est, par exemple, configuré pour définir des trous s'étendant à travers la couche de matériau électriquement isolant et permettant un dépôt sélectif de matériau dans les trous.

Chaque émetteur de lumière 30, 35, 40A et 40B comprend au moins une structure semi-conductrice. Par l'expression « structure semi-conductrice », on entend toute structure constituée au moins partiellement d'un matériau semi-conducteur.

Un empilement de couches semi-conductrices empilées le long de la direction normale D est un exemple de structure semi-conductrice. Une telle structure est souvent appelée « structure bidimensionnelle ».

Une structure semi-conductrice tridimensionnelle ou un ensemble de structures semi-conductrices tridimensionnelles constituent d'autres exemples de structures semi-conductrices.

Une dimension latérale est définie pour chaque émetteur de lumière 30, 35, 40A et 40B. La dimension latérale est la dimension maximale d'un contour entourant l'émetteur de lumière 30, 35, 40A, 40B dans un plan perpendiculaire à la direction normale D, tout en n'entourant aucune partie d'un autre émetteur de lumière 30, 35, 40A, 40B.

La dimension latérale est inférieure ou égale à 20 µm. Par exemple, la dimension latérale est inférieure ou égale à 10 µm. Dans un mode de réalisation, la dimension latérale est inférieure ou égale à 5 µm.

Chaque émetteur de lumière 30, 35, 40A et 40B est configuré pour émettre un rayonnement. Par exemple, chaque structure semi-conductrice de chaque émetteur de lumière 30, 35, 40A et 40B est une structure LED.

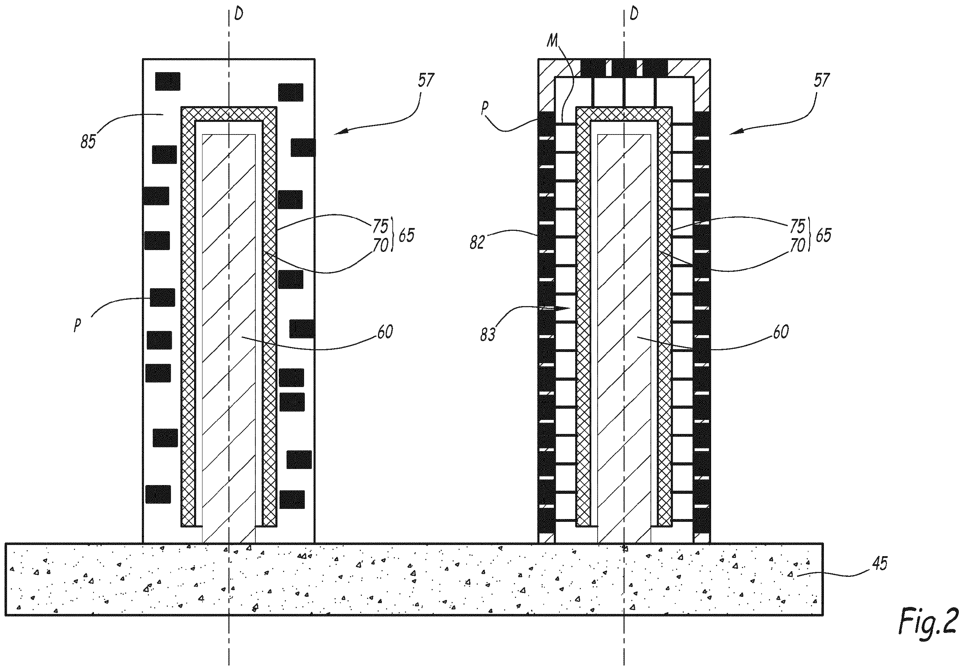

La figure 2 illustre deux exemples de structures semi-conductrices tridimensionnelles 57, chacune formant une structure LED qui peut être utilisée dans l'un quelconque des premier, deuxième ou troisième émetteurs de lumière 30, 35, 40A et 40B.

Chaque structure semi-conductrice tridimensionnelle 57 s'étend à partir du substrat 25 le long de la direction normale D.

La structure tridimensionnelle 57 est, par exemple, un microfil.

Chaque structure semi-conductrice tridimensionnelle 57 comprend un noyau 60 et une couche de couverture 65.

Le noyau 60 joue le rôle soit d'une couche dopée n, soit d'une couche dopée p. Le noyau 60 est constitué d'un matériau semi-conducteur appelé « matériau semi-conducteur de noyau » dans ce qui suit.

Par exemple, le matériau semi-conducteur de noyau est dopé n.

Le matériau semi-conducteur de noyau est, par exemple, GaN.

Le noyau 60 est configuré pour supporter la couche de couverture 65.

Le noyau 60 s'étend à partir du substrat 25 le long de la direction normale D. En particulier, le noyau 60 est connecté électriquement au substrat 25.

Le noyau 60 s'étend, par exemple, à travers la couche électriquement isolante recouvrant une partie de la face de support 50, lorsqu'une telle couche est présente.

Le noyau 60 est, par exemple, un cylindre.

Une surface cylindrique est une surface constituée de tous les points sur toutes les lignes qui sont parallèles à une ligne et qui passent par une courbe plane fixe dans un plan qui n'est pas parallèle à la ligne. Un solide délimité par une surface cylindrique et deux plans parallèles est appelé un « cylindre ». Lorsqu'il est dit qu'un cylindre s'étend dans une direction donnée, cette direction est parallèle à la ligne.

Un cylindre présente une section transversale uniforme le long de la direction dans laquelle le cylindre s'étend.

La section transversale du noyau 60 est polygonale. Par exemple, la section transversale est hexagonale.

Cependant, d'autres formes peuvent être envisagées pour la section transversale.

Il convient de remarquer que la forme du noyau 60 peut varier, par exemple si la structure tridimensionnelle 57 n'est pas un microfil.

Un diamètre est défini pour le noyau 60. Le diamètre est, dans le cas d'un noyau cylindrique 60, la distance maximale entre deux points du noyau 60 qui sont diamétralement opposés dans un plan perpendiculaire à la direction normale D.

Lorsque le noyau 60 présente une section hexagonale, le diamètre du noyau est mesuré entre deux angles opposés de l'hexagone.

Le diamètre du noyau 60 est compris entre 10 nm et 5 µm.

Une longueur mesurée le long de la direction normale D est définie pour le noyau 60. La longueur est comprise entre 10 nm et 100 µm.

Le noyau 60 présente une face supérieure et une face latérale.

La face supérieure délimite le noyau 60 le long de la direction normale D. Par exemple, la face supérieure est perpendiculaire à la direction normale D.

La face latérale entoure le noyau 60 dans un plan perpendiculaire à la direction normale D.

La face latérale s'étend entre la face supérieure et le substrat 25. Lorsque le noyau 60 présente une section polygonale, la face latérale présente un ensemble de facettes planes.

La couche de couverture 65 recouvre au moins partiellement le noyau 60. Par exemple, la couche de couverture 65 recouvre au moins partiellement la face supérieure du noyau. En particulier, la couche de couverture 65 recouvre complètement la face supérieure.

Dans l'exemple illustré dans la figure 2, la couche de couverture 65 recouvre au moins partiellement la face supérieure et au moins partiellement la face latérale.

Comme on peut le voir dans la figure 2, la couche de couverture 65 entoure complètement le noyau 60 dans un plan perpendiculaire à la direction normale D. En d'autres termes, la couche de couverture 65 forme une coquille autour du noyau 60.

La couche de couverture 65 comprend au moins une couche émettrice 70 et une couche dopée 75.

Chaque couche émettrice 70 est interposée entre le noyau 60 et la couche dopée 75.

Par exemple, la couche de couverture 65 comprend un empilement de couches émettrices 70 interposées entre le noyau 60 et la couche dopée 75.

Chaque couche émettrice 70 est, par exemple, un puits quantique. En particulier, l'épaisseur de chaque couche émettrice 70 est, en tout point de la couche émettrice 70, comprise entre 1 nm et 200 nm.

L'épaisseur de chaque couche émettrice 70 est mesurée, en tout point de la couche émettrice 70, le long d'une direction perpendiculaire à la surface du noyau 60 au niveau du point de la surface du noyau 60 qui est le plus proche du point de la couche émettrice 70 considérée.

Par exemple, l'épaisseur de chaque couche émettrice 70 en un point de la couche émettrice 70 qui est aligné avec un point du noyau 60 le long de la direction normale D est mesurée le long de la direction normale D. L'épaisseur de chaque couche émettrice 70 en un point de la couche émettrice 70 qui est aligné dans un plan perpendiculaire à la direction normale avec un point du noyau 60 est mesurée le long d'une direction perpendiculaire à la facette la plus proche du noyau 60.

Chaque couche émettrice 70 est, par exemple, réalisée en InGaN.

La couche dopée 75 recouvre au moins partiellement la ou les couches émettrices 70.

La couche dopée 75 joue le rôle d'une couche dopée n ou d'une couche dopée p de la structure LED.

Le type de dopage (n ou p) de la couche dopée 75 est opposé au type de dopage (p ou n) dans le noyau 60. Par exemple, la couche dopée 75 est dopée p.

La couche dopée 75 est, par exemple, réalisée en GaN.

Lorsqu'un premier, un deuxième ou un troisième émetteur de lumière 30, 35, 40A et 40B comprend au moins une structure semi-conductrice tridimensionnelle 57, un facteur de remplissage de structures semi-conductrices tridimensionnelles 57 est défini pour l'émetteur de lumière 30, 35, 40A et 40B envisagé.

Le facteur de remplissage est le rapport entre la somme des surfaces des sections transversales de toutes les structures semi-conductrices tridimensionnelles 57 fixées à une zone spécifique du substrat 25 et la surface de cette zone.

Par exemple, si le substrat 25 d'un émetteur de lumière 30, 35, 40A et 40B mesure 400 micromètres carrés (µm²) et si cet émetteur de lumière 30, 35, 40A et 40B comprend quatre structures semi-conductrices tridimensionnelles 57 présentant chacune une surface de section transversale de 5 µm², un facteur de remplissage est égal à 4 x 5 / 400 = 1/20.

Lorsqu'un émetteur de lumière 30, 35, 40A et 40B comprend un ensemble de structures semi-conductrices tridimensionnelles 57, un diamètre moyen pour l'ensemble de structures semi-conductrices tridimensionnelles 57 est défini pour l'émetteur de lumière 30, 35, 40A et 40B.

Le diamètre moyen est, par exemple, le diamètre moyen des noyaux 60 des structures semi-conductrices tridimensionnelles 57. La moyenne est, par exemple, une moyenne arithmétique.

Dans un mode de réalisation, les diamètres de tous les noyaux 60 d'un même émetteur de lumière 30, 35, 40A et 40B sont identiques. Dans d'autres modes de réalisation, les diamètres des noyaux 60 d'un même émetteur de lumière 30, 35, 40A et 40B peuvent différer, par exemple jusqu'à 10 %.

Si l'émetteur de lumière 30, 35, 40A et 40B ne comprend qu'une seule structure semi-conductrice tridimensionnelle 57, le diamètre moyen est le diamètre de cette structure tridimensionnelle.

Chaque premier émetteur de lumière 30 est configuré pour émettre le premier rayonnement.

Chaque premier émetteur de lumière 30 comprend une structure semi-conductrice appelée « première structure semi-conductrice ».

Chaque couche émettrice 70 de chaque première structure semi-conductrice est appelée « première couche semi-conductrice ».

Chaque première couche semi-conductrice est constituée d'un premier matériau émetteur semi-conducteur présentant une première bande interdite d'émission.

Le premier matériau émetteur est, par exemple, InGaN.

Chaque première couche semi-conductrice est apte à émettre le premier rayonnement. Par exemple, la composition et/ou l'épaisseur de chaque première couche semi-conductrice sont choisies de sorte que la première longueur d'onde moyenne présente la valeur attendue.

Chaque deuxième émetteur de lumière 35 est configuré pour émettre le deuxième rayonnement.

Chaque deuxième émetteur de lumière 35 comprend une structure semi-conductrice appelée « deuxième structure semi-conductrice ».

Chaque couche émettrice 70 de chaque deuxième structure semi-conductrice est appelée « deuxième couche semi-conductrice ».

Chaque deuxième couche semi-conductrice est constituée d'un deuxième matériau émetteur semi-conducteur présentant une deuxième bande interdite d'émission.

Le deuxième matériau émetteur est, par exemple, différent du premier matériau émetteur. Dans ce cas, la deuxième bande interdite d'émission est différente de la première bande interdite d'émission.

Dans une variante, le deuxième matériau émetteur est identique au premier matériau émetteur, mais l'épaisseur de la deuxième couche semi-conductrice est différente de l'épaisseur de la première couche semi-conductrice, afin d'obtenir l'émission d'un deuxième rayonnement différent du premier rayonnement malgré les bandes interdites identiques. En particulier, la deuxième couche semi-conductrice est un puits quantique, de sorte que la longueur d'onde moyenne du deuxième rayonnement dépend de l'épaisseur de chaque deuxième couche semi-conductrice.

Dans un mode de réalisation spécifique, à la fois l'épaisseur et la composition des première et deuxième couches semi-conductrices sont différentes.

Le deuxième matériau émetteur est, par exemple, InGaN.

Chaque deuxième couche semi-conductrice est apte à émettre le deuxième rayonnement. Par exemple, la composition et/ou l'épaisseur de chaque deuxième couche semi-conductrice sont choisies de sorte que la deuxième longueur d'onde moyenne présente la valeur attendue.

Dans le cas où la première structure semi-conductrice et la deuxième structure semi-conductrice comprennent chacune un ensemble respectif de structures semi-conductrices tridimensionnelles 57, au moins l'un parmi le facteur de remplissage et le diamètre moyen des noyaux 60 peut varier entre le premier émetteur de lumière 30 et le deuxième émetteur de lumière 35. C'est particulièrement le cas lorsque le premier matériau émetteur et le deuxième matériau émetteur comprennent le même ensemble d'éléments chimiques, par exemple si le premier matériau émetteur et le deuxième matériau émetteur sont tous deux InGaN.

Par exemple, le facteur de remplissage des structures semi-conductrices tridimensionnelles 57 est strictement plus petit pour le premier émetteur de lumière 30 plutôt que pour le deuxième émetteur de lumière 35.

Par exemple, le diamètre moyen est strictement plus petit pour le premier émetteur de lumière 30 que pour le deuxième émetteur de lumière 35.

Chaque troisième émetteur de lumière 40A, 40B est configuré pour émettre un quatrième rayonnement.

Chaque quatrième rayonnement est différent du troisième rayonnement émis par le même émetteur de lumière 40A, 40B. En particulier, le quatrième rayonnement présente une quatrième longueur d'onde moyenne, la quatrième longueur d'onde moyenne étant strictement plus courte que la troisième longueur d'onde moyenne. Par exemple, une différence entre le quatrième rayonnement moyen et le troisième rayonnement moyen est supérieure ou égale à 40 nm.

Le quatrième rayonnement est, par exemple, identique à l'un parmi le premier rayonnement et le deuxième rayonnement.

Dans un autre mode de réalisation, le quatrième rayonnement est une lumière ultraviolette. Une lumière ultraviolette est une onde électromagnétique présentant une longueur d'onde comprise entre 10 nm et 400 nm, par exemple entre 200 nm et 400 nm.

Chaque troisième émetteur de lumière 40A, 40B comprend une structure semi-conductrice appelée « troisième structure semi-conductrice » et un convertisseur de rayonnement 80.

Chaque couche émettrice 70 de chaque troisième structure semi-conductrice est appelée « troisième couche semi-conductrice ».

Chaque troisième couche semi-conductrice est constituée d'un troisième matériau émetteur semi-conducteur présentant une troisième bande interdite d'émission.

Chaque troisième couche semi-conductrice est apte à émettre le quatrième rayonnement correspondant. Par exemple, la composition et/ou l'épaisseur de chaque troisième couche semi-conductrice sont choisies de sorte que la quatrième longueur d'onde moyenne présente la valeur attendue.

Dans le cas où le quatrième rayonnement est identique au premier ou au deuxième rayonnement, chaque troisième couche semi-conductrice est identique à la première ou à la deuxième couche semi-conductrice correspondante, respectivement. Par exemple, le facteur de remplissage et le diamètre moyen de la troisième structure semi-conductrice sont respectivement identiques au facteur de remplissage et au diamètre moyen de l'une parmi les première et deuxième structures semi-conductrices.

Dans une variante, le facteur de remplissage et le diamètre moyen de la troisième structure semi-conductrice sont respectivement différents du facteur de remplissage et du diamètre moyen des première et deuxième structures semi-conductrices.

Chaque convertisseur de rayonnement 80 est configuré pour convertir le quatrième rayonnement du troisième émetteur de lumière 40A, 40B comprenant le convertisseur de rayonnement en le troisième rayonnement correspondant.

En revanche, le premier émetteur de lumière 30 et le deuxième émetteur de lumière 35 sont chacun dépourvus de convertisseur de rayonnement 80.

De nombreux types de convertisseurs de rayonnement sont utilisés dans le domaine de l'éclairage, par exemple dans les tubes fluorescents. Ces convertisseurs de rayonnement sont souvent appelés « phosphores ».

Le convertisseur de rayonnement 80 est constitué d'un matériau de conversion.

Le matériau de conversion est configuré pour convertir le quatrième rayonnement en le troisième rayonnement. En d'autres termes, le matériau de conversion est configuré pour être excité par le quatrième rayonnement et à émettre en réponse le troisième rayonnement.

Le matériau de conversion est, par exemple, un matériau semi-conducteur.

Selon d'autres modes de réalisation, le matériau de conversion est un matériau non semi-conducteur tel qu'un grenat d'yttrium-aluminium dopé.

En particulier, le matériau de conversion peut être un phosphore inorganique.

Les particules à base de grenat d'yttrium-aluminium (par exemple, YAG:Ce), les particules à base de grenat d'aluminium-terbium, TAG, (par exemple, TAG:Ce), les particules à base de silicates (par exemple, SrBaSiO4:Eu), les particules à base de sulfures (par exemple, SrGa2S4:Eu, SrS:Eu, CaS:Eu, etc.), les particules à base de nitrures (par exemple, Sr2Si5N8:Eu, Ba2Si5N8:Eu, etc.), les particules à base d'oxynitrures (par exemple, Ca-α-SiAlON:Eu, SrSi2O2N2:Eu, etc.), les particules à base de fluorures (par exemple, K₂SiF6 :Mn, Na2SiF6 :Mn, etc.) sont des exemples de phosphores inorganiques.

De nombreux autres matériaux de conversion peuvent être utilisés, tels que les aluminates dopés, les nitrures dopés, les fluorures dopés, les sulfures dopés, ou les silicates dopés.

Le matériau de conversion est, par exemple, dopé au moyen d'éléments de terres rares, d'éléments de métaux alcalino-terreux ou d'éléments de métaux de transition. Le cérium est, par exemple, parfois utilisé pour le dopage de grenats d'yttrium-aluminium.

Le convertisseur de rayonnement 80 comprend, par exemple, un ensemble de particules P réalisées en le matériau de conversion. Ces particules P sont parfois appelées « luminophores ».

Chaque particule P présente, par exemple, un diamètre inférieur ou égal à 2 µm. En particulier, chaque particule P présente un diamètre inférieur ou égal à 1 µm. Dans un mode de réalisation, chaque particule P présente un diamètre inférieur ou égal à 500 nm, par exemple inférieur ou égal à 200 nm.

En d'autres termes, si chaque particule P présente un diamètre inférieur ou égal à 2 µm, la valeur D100 pour l'ensemble des particules est inférieure ou égale à 2 µm.

Dans un mode de réalisation, chaque particule P est une boîte quantique.

Les boîtes quantiques peuvent être sélectionnées parmi les nanocristaux semi-conducteurs du groupe II-VI, du groupe III-V, du groupe IV-VI ou d'un mélange de ceux-ci.

Les nanocristaux semi-conducteurs du groupe II-VI peuvent inclure, sans toutefois s'y limiter : CdS, CdSe, CdTe, ZnS, ZnSe, ZnTe, HgS, HgSe, HgTe, CdSeS, CdSeTe, CdSTe, ZnSeS, ZnSeTe, ZnSTe, HgSeS, HgSeTe, HgSTe.

Les nanocristaux semi-conducteurs du groupe III-V peuvent inclure, sans toutefois s'y limiter : GaN, GaP, GaAs, AIN, AIP, AlAs, InN, InP, InAs, InGaN, GaNP, GaNAs, GaPAs, AINP, AINAs, AlPAs et InAIPAs.

Les nanocristaux semi-conducteurs du groupe IV-VI peuvent inclure, sans toutefois s'y limiter : SbTe, PbSe, GaSe, PbS, PbTe, SnS, SnTe, PbSnTe. Les nanocristaux semi-conducteurs de type chalcopyrite sélectionnés à partir du groupe constitué de CulnS2, CulnSe2, CuGaS2, CuGaSe2, AgInS2, AglnSe2, AgGaS2, et AgGaSe2 pourraient également être envisagés.

Un autre exemple de boîte quantique est la particule P présentant un noyau et une coquille entourant le noyau, le noyau étant constitué d'un matériau de conversion semi-conducteur et présentant une dimension maximale comprise entre 1 nm et 200 nm.

Le noyau peut comprendre, par exemple, un nanocristal tel que ceux décrits ci-dessus.

La coquille peut être constituée de ZnS, CdS, ZnSe, CdSe, ou de tout mélange de ceux-ci.

Les boîtes quantiques peuvent également être protégés contre l'oxydation en utilisant une couche de protection en oxyde métallique, une couche de protection en nitrure métallique, une couche de protection en oxynitrure ou un mélange de celles-ci.

Une couche de protection en oxyde métallique peut être sélectionnée, sans toutefois s'y limiter, à partir du groupe constitué par Al2O3, SiO2, TiO2, ZrO2, B2O3, Co2O3, Cr2O3, CuO, Fe2O3, Ga2O3, HfO2, In2O3, MgO, Nb2O5, NiO, SnO2, et Ta2O5.

Les nitrures métalliques peuvent être par exemple BN, AIN, GaN, InN, Zr3N4, CuZN, etc.

Une couche de protection en oxynitrure pourrait inclure, mais sans s'y limiter, du SiON.

L'épaisseur de la couche de protection peut varier de 1 à 400 nm, de préférence de 1 à 100 nm.

Il convient de remarquer que la forme de la boîte quantique peut varier. Des exemples de boîtes quantiques de formes différentes peuvent être appelés nanotiges, nanofils, tétrapodes, nanopyramides, nanocubes, etc.

Il convient de remarquer que chaque particule P peut comprendre plus d'une boîte quantique, par exemple en intégrant les boîtes quantiques dans une microsphère de silice poreuse, ou en agrégeant plusieurs boîtes quantiques.

Dans un mode de réalisation, l'ensemble de particules P comprend un ensemble de boîtes quantiques et un ensemble de particules neutres. Les particules neutres sont des particules transparentes pour le troisième rayonnement. Par exemple, les particules neutres sont transparentes à la fois pour le troisième rayonnement et pour le quatrième rayonnement.

Les nanoparticules de SiO2, TiO2 ou Al2O3 sont des exemples de particules neutres.

Les particules neutres peuvent présenter un diamètre compris entre 50 nm et 1 µm.

Le rapport des particules neutres aux boîtes quantiques, en poids, peut être inférieur ou égal à 2/1 (particules neutres/ boîtes quantiques), par exemple compris entre 0,1/1 et 1/1.

Les particules P d'au moins l'un des troisièmes émetteurs de lumière 40A, 40B peuvent, par exemple, être noyées dans une résine photosensible. Les résines photosensibles, également appelées « photoresists », sont utilisées dans de nombreuses techniques de fabrication électronique pour définir des motifs sur une surface semi-conductrice, en particulier, étant donné que des zones spécifiques de la résine peuvent être solidifiées, tout en permettant que d'autres zones soient supprimées, afin de définir les motifs. Les zones à enlever ou à solidifier sont définies par insolation à l'aide d'une longueur d'onde lumineuse à laquelle la résine est sensible. Une telle résine photosensible est notamment utilisée pour protéger les zones couvertes contre le dépôt de matériaux ou la gravure.

Dans un mode de réalisation ne faisant pas partie de l'invention, toutes les structures semi-conductrices tridimensionnelles 57 du troisième émetteur de lumière 40A, 40B sont noyées dans une masse de résine 85 contenant des particules P du matériau de conversion.

Un exemple de structure tridimensionnelle 57 noyée dans une masse de résine 85 contenant des particules P du matériau de conversion est illustré à gauche dans la figure 2.

Lorsque la troisième structure semi-conductrice correspondante comprend au moins une structure tridimensionnelle 57, la masse de résine présente une hauteur, mesurée le long de la direction normale D, supérieure ou égale à la hauteur des structures tridimensionnelles.

Dans le cas où la troisième structure semi-conductrice est une structure bidimensionnelle, la masse de résine correspondante recouvre, par exemple, au moins partiellement une surface exposée de la troisième structure semi-conductrice.

En variante, chaque particule P est fixée à une troisième structure semi-conductrice.

Un exemple de convertisseur de rayonnement 80 comprenant des particules P d'un matériau de conversion fixées à une structure semi-conductrice tridimensionnelle 57 d'une troisième structure semi-conductrice est illustré à droite dans la figure 2.

Par exemple, une surface de la troisième structure semi-conductrice est au moins partiellement recouverte par les particules P. Dans l'exemple présenté dans la figure 2, la totalité de la surface de chaque structure semi-conductrice tridimensionnelle 57 comprise dans la troisième structure semi-conductrice est recouverte d'une couche 82 de particules P.

Chaque particule P est fixée à la surface de la troisième structure semi-conductrice par greffage.

Le greffage est un procédé permettant de fixer des particules P à une surface, dans lequel la surface est recouverte d'une couche propre à fixer les particules P à la surface. La surface est fonctionnalisée en utilisant des molécules M fixées à la surface et propre à permettre à chaque particule P de se fixer à la surface via la molécule M. En particulier, une extrémité de chaque molécule M est propre à se fixer à une surface de la troisième structure semi-conductrice et une autre extrémité est apte à se fixer à une particule P du matériau de conversion, de sorte que la particule P est fixée à la troisième structure semi-conductrice par la molécule M.

Tel que montré dans la figure 2, le convertisseur de rayonnement comprend une couche de greffage 83 constituée des molécules M, la couche 82 étant fixée à la surface de la troisième structure semi-conductrice par la couche de greffage 83.

Ces molécules M sont parfois appelées « agents de surface », « ligands bifonctionnels », « ligands polyfonctionnels », « liants », « lieurs », « agents de recouvrement », etc.

Il convient de remarquer que toute molécule organique fonctionnelle présentant au moins deux groupes réactifs fonctionnels peut être utilisée en tant que molécule M dans la présente invention.

Des exemples de molécules M peuvent être sélectionnés, par exemple, parmi le groupe « organosilane », le groupe « thiol », le groupe « acrylate » et le groupe « amine ».

Le groupe « organosilane » comprend, par exemple, les molécules 3-aminopropyltriméthoxysilane, 3-mercaptopropyltriméthoxysilane, 3-(méthacryloyloxy)propyltriméthoxysilane et allyltriméthoxysilane.

Le groupe « thiol » comprend, par exemple, les molécules 1,6-hexanédithiol, triméthylolpropane tris(3-mercaptopropionate), pentaérythritol tétrakis(3-mercaptopropionate).

Les acrylates sont par exemple le poly(éthylèneglycol)diacrylate, le triacrylate de pentaérythritol et le tétraacrylate de pentaérythritol.

Les molécules M du groupe « amine » incluent les molécules bis(hexaméthylène)triamine, bis(3-aminopropyl)amine, 3,3'-diamino-N-méthyldipropylamine, etc.

La longueur de chaque molécule M est choisie de manière à imposer une distance moyenne entre les particules. La longueur de chaque molécule M est notamment choisie de manière à limiter le risque d'absorption, par une particule P, d'un troisième rayonnement émis par une particule P voisine.

Il convient de remarquer que des modes de réalisation dans lesquels plusieurs couches de greffage 83 et plusieurs couches de particules P sont empilées peuvent être envisagés. Par exemple, une couche de greffage 83 est utilisée pour fixer une première couche 82 de particules P, chaque autre couche 82 de particules P étant fixée à une couche sous-jacente 82 de particules P par une couche de greffage 83 interposée entre les deux couches 82.

Dans la description ci-dessus, chaque convertisseur de rayonnement 80 a été décrit comme étant fixé à une surface de la première, deuxième ou troisième structure semi-conductrice correspondante. Il convient de remarquer que des modes de réalisation dans lesquels tout type de convertisseur de rayonnement 80 est fixé à une autre surface du troisième émetteur de lumière correspondant 40A, 40B peuvent être envisagés. Par exemple, la masse de résine 85 ou une couche 83 de molécules M peut fixer les particules P à une face arrière du substrat 25 directement opposée à la troisième structure semi-conductrice correspondante.

Le circuit de commande est configuré pour injecter un courant électrique dans chaque émetteur de lumière 30, 35, 40A et 40B.

En particulier, le circuit de commande est configuré pour injecter un courant électrique dans chaque structure LED de chaque émetteur de lumière 30, 35, 40A et 40B, par exemple dans chaque structure semi-conductrice tridimensionnelle 57.

Le circuit de commande est configuré de sorte que chaque courant électrique circule à travers la couche dopée n, la ou les couches émettrices et la couche dopée p de la structure LED correspondante.

Par exemple, le circuit de commande comprend, pour chaque structure LED, un contact électrique connecté électriquement au noyau 60, en particulier par l'intermédiaire du substrat 25, et un contact électrique connecté électriquement à la couche dopée 75, et est propre à imposer une tension électrique entre les deux contacts électriques.

Au moins l'un des contacts électriques est, par exemple, constitué d'un matériau conducteur transparent. En particulier, le contact électrique connecté électriquement à la couche dopée 75 est constitué d'un matériau conducteur transparent.

L'oxyde d'indium-étain est un exemple d'un tel matériau conducteur transparent.

Dans un mode de réalisation, chaque émetteur 30, 35, 40A, 40B est séparé de tout autre émetteur 30, 35, 40A, 40B par une paroi 95 s'étendant sur le substrat 25.

Par exemple, chaque paroi 95 entoure un émetteur correspondant 30, 35, 40A, 40B dans un plan perpendiculaire à la direction normale D.

Chaque paroi 95 présente une hauteur supérieure ou égale à la hauteur des structures tridimensionnelles 57, par exemple au moins un micromètre de plus que la hauteur des structures tridimensionnelles 57. Dans un mode de réalisation, la différence de hauteur entre la paroi 95 et les structures tridimensionnelles 57 est comprise entre 1 µm et 2 µm.

La hauteur de chaque paroi 95 est, par exemple, inférieure ou égale à 15 µm.

Chaque paroi 95 est configurée pour empêcher qu'un rayonnement émis par un émetteur 30, 35, 40A, 40B n'atteigne un autre émetteur 30, 35, 40A, 40B.

Chaque paroi 95 est, par exemple, configurée pour réfléchir le rayonnement. Dans une variante possible, la paroi 95 est configurée pour absorber le rayonnement.

En particulier, la paroi 95 est configurée pour empêcher que le premier, le deuxième ou le troisième rayonnement émis par l'émetteur 30, 35, 40A, 40B n'atteigne tout autre émetteur 30, 35, 40A, 40B.

En variante, la paroi 95 est configurée pour empêcher que le quatrième rayonnement émis par la structure semi-conductrice d'un émetteur 40A, 40B ne quitte l'émetteur 40A, 40B.

La paroi 95 est, par exemple, constituée d'une résine photosensible. Dans une variante possible, la paroi est faite d'un métal tel que l'aluminium. Des parois 95 en cuivre Cu ou en alliage or/cuivre peuvent également être envisagées.

Dans une autre variante, la paroi 95 est en argent ou en un matériau recouvert d'une couche d'argent.

Dans un autre mode de réalisation, la paroi 95 comprend un réflecteur de Bragg. Un réflecteur de Bragg est un réflecteur constitué d'un empilement de couches constituées de différents matériaux, la différence d'indices optiques entre les différents matériaux occasionnant la réflexion de certains rayonnements optiques par le réflecteur.

Dans un mode de réalisation, un filtre de rayonnement recouvre au moins un troisième émetteur de lumière 40A, 40B, 40C. Le filtre de rayonnement recouvre, par exemple, chaque troisième émetteur de lumière 40A, 40B, 40C, ou recouvre même chaque émetteur de lumière 30, 35, 40A, 40B, 40C.

Le filtre de rayonnement est configuré pour empêcher que le quatrième rayonnement ne quitte le troisième émetteur de lumière 40A, 40B, 40C, par exemple en absorbant toute composante du quatrième rayonnement qui n'a pas été convertie par le convertisseur de rayonnement 80. En particulier, le filtre de rayonnement forme une barrière entre le convertisseur de rayonnement 80 et l'atmosphère extérieure.

Plusieurs exemples de dispositifs émetteurs 15 seront à présent détaillés.

Le premier exemple concerne un dispositif émetteur 15 comprenant au moins deux émetteurs de lumière de couleur naturelle 30, 35 et au moins deux émetteurs de lumière converti 40A, 40B.

Les deuxième et troisième exemples concernent des dispositifs émetteurs 15 présentant au moins deux émetteurs de lumière convertis 40A, 40B, 40C, au moins l'un des émetteurs de lumière présentant un convertisseur de rayonnement 80 réalisé par greffage et au moins l'un des autres émetteurs de lumière présentant un convertisseur de rayonnement 80 comprenant des particules noyées dans une masse de résine.

Le quatrième exemple ne fait pas partie de l'invention et concerne un dispositif émetteur présentant au moins deux émetteurs de lumière convertis 40A, 40B, chacun des convertisseurs étant excité par un rayonnement présentant une longueur d'onde différente de celle du rayonnement excitant l'autre convertisseur.

PREMIER EXEMPLE DE DISPOSITIF ÉMETTEUR COMPRENANT DEUX ÉMETTEURS DE LUMIÈRE DE COULEUR NATURELLE ET AU MOINS UN ÉMETTEUR DE LUMIÈRE CONVERTI.

Un premier exemple d'écran d'affichage 10 est partiellement illustré dans la figure 1.

L'ensemble d'émetteurs de lumière du premier exemple de l'écran d'affichage 10 comprend un premier émetteur de lumière 30, un deuxième émetteur de lumière 35 et au moins un troisième émetteur de lumière 40A, 40B.

Il convient de remarquer que le nombre des premiers, deuxièmes et troisièmes émetteurs de lumière 30, 35, 40A, 40B peut varier. Par exemple, le dispositif émetteur 15 peut comprendre plus d'un premier émetteur de lumière 30 et/ou plus d'un deuxième émetteur de lumière 35.

En outre, le nombre de troisièmes émetteurs 40A, 40B est strictement supérieur à un. Dans le mode de réalisation illustré dans la figure 1, le dispositif émetteur 15 comprend deux troisièmes émetteurs de lumière 40A, 40B.

La première structure semi-conductrice comprend au moins une structure semi-conductrice tridimensionnelle 57.

Dans le mode de réalisation illustré dans la figure 1, la première structure semi-conductrice comprend un ensemble de structures semi-conductrices tridimensionnelles 57.

La deuxième structure semi-conductrice comprend au moins une structure semi-conductrice tridimensionnelle 57.

Dans le mode de réalisation illustré dans la figure 1, la deuxième structure semi-conductrice comprend un ensemble de structures semi-conductrices tridimensionnelles 57.

Chaque troisième structure semi-conductrice comprend au moins une structure semi-conductrice tridimensionnelle 57.

Dans le mode de réalisation illustré dans la figure 1, chaque troisième structure semi-conductrice comprend un ensemble de structures semi-conductrices tridimensionnelles 57.

Tel que susmentionné, le premier émetteur de lumière 30 et le deuxième émetteur de lumière 35 sont dépourvus de convertisseur de rayonnement 80, tandis que les deux troisièmes émetteurs de lumière 40A et 40B comprennent chacun un convertisseur de rayonnement 80.

Dans le mode de réalisation illustré dans la figure 1, le convertisseur de rayonnement 80 d'un troisième émetteur de lumière 40A comprend des particules P noyées dans une résine et le convertisseur de rayonnement 80 d'un autre troisième émetteur de lumière 40B comprend des particules P fixées à la troisième structure semi-conductrice.

Un procédé de fabrication d'un dispositif émetteur 15 est à présent détaillé.

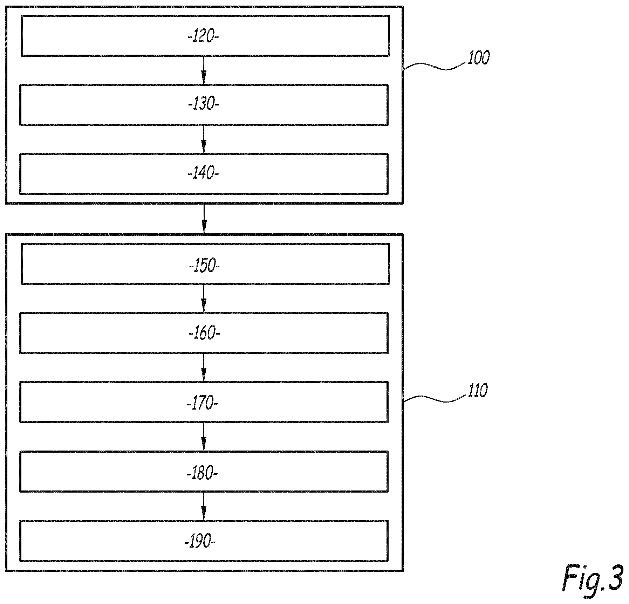

Un ordinogramme montrant l'ordre des étapes d'un exemple de procédé de fabrication d'un dispositif émetteur 15 est illustré dans la figure 3. En particulier, la fabrication du premier exemple de dispositif émetteur 15 est décrite. Cependant, l'extension de ce procédé à la fabrication d'autres exemples de dispositifs émetteurs est immédiate.

Le procédé comprend une étape de fabrication 100 et une étape de positionnement 110.

Au cours de l'étape de fabrication 100, chaque première, deuxième et troisième structure semi-conductrice est fabriquée.

L'étape de fabrication 100 comprend une étape de fourniture 120, une étape de dépôt 130 et une étape de traitement 140.

Au cours de l'étape de fourniture 120, le substrat 25 est fourni dans une chambre de dépôt.

Le substrat 25 comprend un support pour chacune des première, deuxième et troisième structures semi-conductrices.

Par exemple, lorsqu'une première, deuxième ou troisième structure semi-conductrice est une structure bidimensionnelle, le support correspondant comprend la couche dopée n ou dopée p qui est la plus proche du substrat 25.

Lorsqu'une première, deuxième ou troisième structure semi-conductrice comprend au moins une structure tridimensionnelle 57, le support comprend le noyau 60 de chaque structure tridimensionnelle 57.

Chaque support est, par exemple, fourni en déposant le matériau de noyau sur le substrat 25.

De nombreuses techniques de dépôt peuvent permettre d'obtenir un tel support.

Par exemple, le dépôt en phase vapeur par procédé chimique organométallique (MOCVD) est un moyen permettant d'obtenir des noyaux de microfils, en particulier lorsque le matériau est déposé sélectivement dans les trous de la couche électriquement isolante du substrat 25.

Le dépôt MOCVD est également appelé « MOVPE », ce qui signifie « épitaxie en phase vapeur par procédé chimique organométallique ». D'autres procédés de dépôt chimique en phase vapeur (CVD) peuvent également être envisagés.

Toutefois, d'autres techniques de dépôt peuvent être utilisées, par exemple l'épitaxie par jets moléculaires (MBE), la MBE à source gazeuse (GSMBE), l'épitaxie par jets moléculaires organométallique (MOMBE), l'épitaxie par jets moléculaires assistée par plasma (PAMBE), l'épitaxie par couche atomique (ALE) ou l'épitaxie en phase vapeur aux hydrures (HVPE).

À la fin de l'étape de fourniture 120, le substrat 25 comprenant les supports correspondant à chaque première, deuxième ou troisième structure semi-conductrice est ainsi fourni dans la chambre de dépôt.

En variante, les supports correspondant à chaque première, deuxième ou troisième structure semi-conductrice sont fabriqués dans une chambre de dépôt différente de la chambre dans laquelle le substrat 25 comprenant les supports correspondant à chaque première, deuxième ou troisième structure semi-conductrice est présent à la fin de l'étape de fourniture.

Au cours de l'étape de dépôt 130, chaque première, deuxième et troisième couche semi-conductrice est fabriquée en déposant, respectivement, le premier, le deuxième et le troisième matériau émetteur sur les supports correspondant respectivement aux première, deuxième et troisième structures semi-conductrices.

Par exemple, les premier, deuxième et troisième matériaux émetteurs sont déposés simultanément sur les supports correspondants.

Une étape de dépôt 130 au cours de laquelle les supports sont des noyaux 60 de structures tridimensionnelles 57 est un exemple d'une telle étape de dépôt simultanée 130. En effet, la variation du facteur de remplissage et/ou du diamètre de noyau d'un émetteur de lumière 30, 35, 40A et 40B à un autre amène la composition et/ou l'épaisseur des premier, deuxième et troisième matériaux émetteurs déposés à être mutuellement différentes, même si le premier, le deuxième et le troisième matériau émetteur ont été déposés simultanément dans les mêmes conditions.

En variante, plusieurs étapes de dépôt successives sont mises en oeuvre en vue d'obtenir les première, deuxième et troisième couches semi-conductrices.

À la fin de l'étape de dépôt, les première, deuxième et troisième structures semi-conductrices sont obtenues.

Par exemple, la couche dopée 75 est déposée sur la ou les couches émettrices 70 de chaque structure tridimensionnelle 57.

Lorsqu'une première, deuxième ou troisième structure semi-conductrice est une structure bidimensionnelle, la couche, parmi les couches dopées n ou p, qui est la plus éloignée du substrat 25, est déposée sur la ou les couches émettrices.

Au cours de l'étape de traitement 140, les contacts électriques sont formés.

Au cours de l'étape de positionnement 110, le convertisseur de rayonnement 80 de chaque troisième émetteur de lumière est positionné.

L'étape de positionnement 110 comprend une étape de masquage 150, une étape de fonctionnalisation 160, une étape de dépôt d'un convertisseur 170, une étape de retrait 180 et une étape de finition 190.

Au cours de l'étape de masquage 150, la première structure semi-conductrice et la deuxième structure semi-conductrice sont recouvertes d'une résine photosensible, ainsi que toute troisième structure semi-conductrice dont le convertisseur de rayonnement associé 80 ne comprend pas de particules P greffées à la troisième structure semi-conductrice.

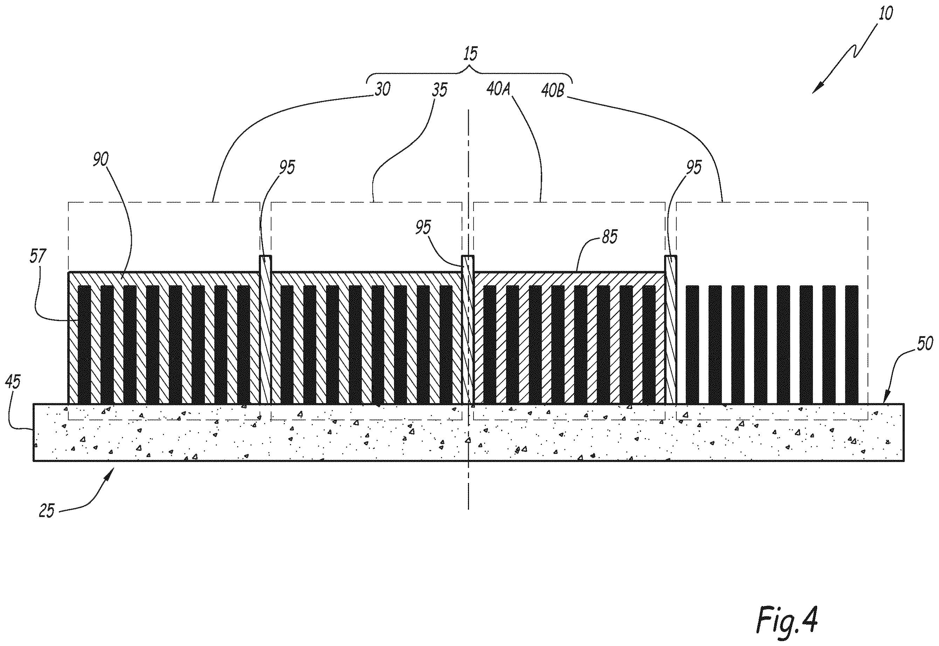

Un exemple de l'état du substrat 25 et des différentes structures semi-conductrices à la fin de l'étape de masquage 150 est illustré dans la figure 4.

Dans l'exemple illustré dans la figure 4, la troisième structure semi-conductrice de l'un des troisièmes émetteurs de lumière 40A est recouverte de résine photosensible au cours de l'étape de masquage 150. La troisième structure semi-conductrice de l'autre troisième émetteur de lumière 40B n'est pas recouverte de résine photosensible.

Dans un mode de réalisation, la troisième structure semi-conductrice du troisième émetteur de lumière 40A est recouverte d'une première masse 85 de résine photosensible et la première structure semi-conductrice et la deuxième structure semi-conductrice sont recouvertes d'une deuxième masse 90 de résine photosensible.

La première masse 85 comprend, par exemple, des particules P d'un matériau de conversion de sorte que la première masse 85 forme le convertisseur de rayonnement 80 du troisième émetteur de lumière 40A.

Au cours de l'étape de fonctionnalisation 160, les molécules M sont déposées sur la troisième structure semi-conductrice du troisième émetteur de lumière 40B afin de former la couche de greffage 83.

Par exemple, la zone où les molécules M doivent être déposées est définie par masquage. En particulier, une résine photosensible est déposée sur le substrat 25 et sur les différentes structures semi-conductrices, par exemple par dépôt à la tournette. La résine photosensible est ensuite insolée sélectivement et une partie de la résine photosensible est retirée afin de ne laisser que la troisième structure semi-conductrice du troisième émetteur 40B dépourvue de résine photosensible.

La surface de la structure semi-conductrice du troisième émetteur 40B est ensuite activée par exposition à un flux d'ozone ou à une lumière ultraviolette.

La surface activée est ensuite fonctionnalisée avec une couche 83 de molécules M.

À la fin de l'étape de fonctionnalisation 160, la surface de la structure semi-conductrice du troisième émetteur 40B est ainsi recouverte d'une couche 83 de molécules M qui sont chacune fixées à la surface de la structure semi-conductrice.

Chaque molécule M est, en particulier, fixée à la surface par l'un des groupes réactifs fonctionnels de la molécule M.

L'étape de dépôt d'un convertisseur 170 est également appelée « étape de greffage ».

Au cours de l'étape de dépôt d'un convertisseur 170, les particules P sont déposées sur la couche de greffage 83. Chaque particule P est fixée à la surface de la troisième structure semi-conductrice par une ou plusieurs des molécules M de la couche de greffage 83. La couche 82 de particules P est ainsi formée et fixée à la troisième structure semi-conductrice.

En particulier, chaque particule P est attachée à la molécule M par l'un des groupes réactifs fonctionnels de la molécule M.

À la fin de l'étape 170 de dépôt d'un convertisseur, une couche 82 de particules P est ainsi fixée à la structure semi-conductrice du troisième émetteur 40B par la couche 83 de molécules M.

Il convient de remarquer que les étapes 160 et 170 peuvent être répétées de façon à former un ensemble de couches empilées 82 et 83.

Au cours de l'étape de retrait 180, la deuxième masse de résine 90 est retirée.

Si une première masse 85 de résine est présente, la première masse 85 n'est pas retirée.

Au cours de l'étape de finition 190, le dispositif émetteur 15 est terminé.

Par exemple, chaque contact électrique qui n'a pas encore été fabriqué est fabriqué au cours de l'étape de finition 190. Chaque contact électrique est connecté au circuit de commande.

Le dispositif émetteur 15 est, par exemple, recouvert d'une couche de passivation transparente, de sorte que chaque structure tridimensionnelle 57 est noyée dans la couche de passivation.

En outre, le dispositif émetteur 15 est intégré à un autre dispositif émetteur 15 pour former les pixels de l'écran d'affichage 10.

Le procédé comprend en outre, facultativement, une étape de formation des parois 95.

L'étape de formation des parois 95 est, par exemple, mise en oeuvre après l'étape de dépôt 130 et avant l'étape de traitement 140.

Les parois 95 sont, par exemple, formées en déposant une couche d'une résine photosensible opaque et en insolant localement la couche de résine opaque pour définir les parois 95.

D'autres techniques de dépôt de matériaux peuvent être envisagées pour former les parois, par exemple les procédés de dépôt MOCVD, procédés de dépôt MOVPE, d'autres procédés de dépôt CVD, les procédés d'épitaxie MBE, GSMBE, MOMBE, PAMBE, ALE, HVPE, d'électrodéposition ou de pulvérisation.

Le premier exemple d'écran d'affichage 10 est décrit ci-dessus dans un cas où chaque dispositif émetteur 15 comprend un premier émetteur de lumière 30, un deuxième émetteur de lumière 35 et deux troisièmes émetteurs de lumière 40A, 40B, chaque troisième émetteur de lumière 40A, 40A, 40B présentant un convertisseur de rayonnement 80 réalisé avec une technique (noyage dans une masse de résine 85 ou greffage) différente de la technique utilisée pour le convertisseur de rayonnement 80 de l'autre troisième émetteur de lumière 40A, 40B.

Il convient de remarquer que des variantes du premier exemple ne faisant pas partie de l'invention peuvent inclure ur unique troisième émetteur de lumière 40A, 40B, ou deux troisièmes émetteurs de lumière 40A, 40B, faisant appel à une même technique pour former leurs convertisseurs de rayonnement 80 respectifs. Dans ce cas, en ce qui concerne l'étape de positionnement 110, seules les étapes correspondantes parmi les étapes 150 à 190 sont mises en oeuvre.

Dans l'exemple ci-dessus, la couche de greffage 83 a été décrite comme étant déposée uniquement sur les parties de la surface de la troisième structure semi-conductrice à laquelle les particules P correspondantes doivent être fixées.

Il convient de remarquer que des modes de réalisation dans lesquels la couche de greffage 83 est déposée sur une surface plus grande que la surface à laquelle les particules P doivent être fixées, et supprimée localement après le dépôt des particules P, sont également envisagés. Par exemple, une première partie 86 et une deuxième partie 87 de la couche de greffage 83 sont déposées, les particules P sont fixées à la première partie 86 et à la deuxième partie 87, et la deuxième partie est retirée après le dépôt des particules P, laissant ainsi les particules P fixées uniquement à la première partie 86.

Une gravure au plasma de la deuxième partie 87 constitue un exemple de procédé permettant de retirer localement une partie de la couche de greffage 83.

Étant donné que deux émetteurs de lumière 30, 35 sont dépourvus de convertisseur de rayonnement 80, le nombre d'étapes nécessaires pour déposer le ou les convertisseurs de rayonnement 80 est réduit. Le risque de mélange entre les convertisseurs de rayonnement 80 est par conséquent réduit. Par conséquent, les plages de longueurs d'onde émises par chaque dispositif émetteur 15 sont bien commandées même si les dimensions du dispositif émetteur 15 sont réduites. Les dimensions de l'écran d'affichage 10 sont ainsi réduites et la résolution de l'écran d'affichage 10 est améliorée.

La présence des parois 95 réduit en outre le risque de diaphonie entre les émetteurs de lumière voisins 30, 35, 40A, 40B et 40C, étant donné que de telles parois 95 réduisent le risque que la lumière émise par un émetteur de lumière 30, 35, 40A, 40B et 40C n'atteigne un autre émetteur de lumière 30, 35, 40A, 40B et 40C. La résolution de l'écran d'affichage est ainsi également améliorée.

En outre, la présence des parois 95 permet un placement plus facile du convertisseur de rayonnement 80, étant donné que les parois 95 forment une barrière limitant le risque que les particules P déposées sur une structure semi-conductrice soient également déposées sur une autre structure semi-conductrice.

Les structures tridimensionnelles, et en particulier les microfils, permettent à la première structure semi-conductrice et à la deuxième structure semi-conductrice d'émettre des rayonnements présentant des longueurs d'onde moyennes différentes, y compris si les matériaux émetteurs correspondants sont déposés simultanément dans les mêmes conditions. Une telle différence est en particulier commandée avec précision si le facteur de remplissage et/ou le diamètre moyen varient entre la première structure semi-conductrice et la deuxième structure semi-conductrice.

Les structures bidimensionnelles sont plus faciles à fabriquer que les structures tridimensionnelles.

Les particules P d'un matériau de conversion peuvent être facilement déposées en faisant appel à un nombre de techniques distinctes.

En particulier, le dépôt de particules P noyées dans une résine correspond à un procédé simple qui ne nécessite que des techniques standard couramment utilisées dans le domaine de l'électronique, et donc facilement contrôlables. Le convertisseur de rayonnement 80 ainsi obtenu est donc très stable au cours des étapes de traitement subséquentes.

Le procédé de greffage ne nécessite pas d'étape d'insolation des particules P avec un rayonnement optique spécifique, étant donné que la zone où les particules P seront fixées est définie en positionnant la couche de greffage 83 avant que les particules P ne soient déposées. Par conséquent, il n'y a pas de dispersion du rayonnement optique par les particules P, et le positionnement du convertisseur de rayonnement est donc très précis. Les dimensions du dispositif émetteur 15 peuvent ici aussi être réduites sans compromettre la pureté de la couleur.

En outre, le greffage permet d'obtenir une densité de surface élevée des particules P, et par conséquent une conversion efficace du quatrième rayonnement en le troisième rayonnement.

Les molécules M ne se fixent pas à la résine photosensible. Par conséquent, lorsqu'un troisième émetteur de lumière 40A comprend des particules P noyées dans une résine et qu'un troisième émetteur de lumière 40B comprend des particules P fixées par greffage, le mélange des deux convertisseurs de rayonnement 80 est évité, y compris lorsque les dimensions du dispositif émetteur 15 sont réduites.

Les structures semi-conductrices émettant efficacement de la lumière bleue ou verte présentent généralement une faible efficacité lorsqu'elles sont adaptées pour émettre de la lumière rouge. En particulier, les matériaux adaptés pour émettre de la lumière bleue ou verte sont généralement différents de ceux adaptés pour émettre de la lumière rouge ou blanche. Si le ou les quatrièmes rayonnements sont identiques à l'un des premier et deuxième rayonnements, ou si le troisième rayonnement est une lumière rouge ou blanche, la fabrication du dispositif émetteur 15 s'en trouve donc simplifiée, étant donné que toutes les structures semi-conductrices peuvent être constituées de la même famille de matériaux et peuvent être identiques ou similaires entre elles, tout en conservant une bonne efficacité d'émission globale pour chacun des premier, deuxième et troisième rayonnements.

Lorsque des particules neutres sont mélangées avec des boîtes quantiques dans l'ensemble de particules P, la distance moyenne entre les boîtes quantiques peut être commandée de manière à limiter l'absorption, par une boîte quantique, du troisième rayonnement émis par une autre boîte quantique. L'efficacité d'émission globale est par conséquent augmentée.

Les différentes structures semi-conductrices ont été décrites ci-dessus dans le cas où chaque matériau semi-conducteur est un matériau de nitrure d'élément III. Toutefois, d'autres matériaux semi-conducteurs peuvent être utilisés.

En outre, les première, deuxième et troisième structures semi-conductrices ont été décrites dans les figures 1 à 5 comme comprenant chacune un ensemble de structures tridimensionnelles. Cependant, l'une quelconque des première, deuxième et troisième structures semi-conductrices peut être une structure bidimensionnelle unique.

Alors que le premier exemple d'écran d'affichage 10 et sa variante permettent d'améliorer la résolution spatiale en utilisant au moins deux émetteurs de lumière 30, 35 dépourvus de convertisseur de rayonnement 80, d'autres exemples d'écran d'affichage utilisant un émetteur de lumière 30, 35 ou moins peuvent également fournir une résolution spatiale améliorée par rapport aux écrans 15 existants.

Dans chacun des exemples suivants, une résolution spatiale améliorée est obtenue en modifiant au moins une caractéristique de chaque troisième émetteur de lumière 40A, 40B, 40C par rapport à l'autre ou aux autres troisièmes émetteurs de lumière 40A, 40B et 40C.

DEUXIÈME EXEMPLE DE DISPOSITIF ÉMETTEUR COMPRENANT AU MOINS DEUX ÉMETTEURS DE LUMIÈRE CONVERTIS UTILISANT DES TECHNOLOGIES DIFFÉRENTES.

Dans un deuxième exemple, cette résolution spatiale améliorée est obtenue en faisant appel à des techniques distinctes pour les différents convertisseurs de rayonnement 80.

Le deuxième exemple d'écran d'affichage 10 sera à présent décrit. Tous les éléments identiques à ceux du premier exemple des figures 1 à 4 ne sont pas décrits à nouveau. Par conséquent, seules les différences sont détaillées ci-après.

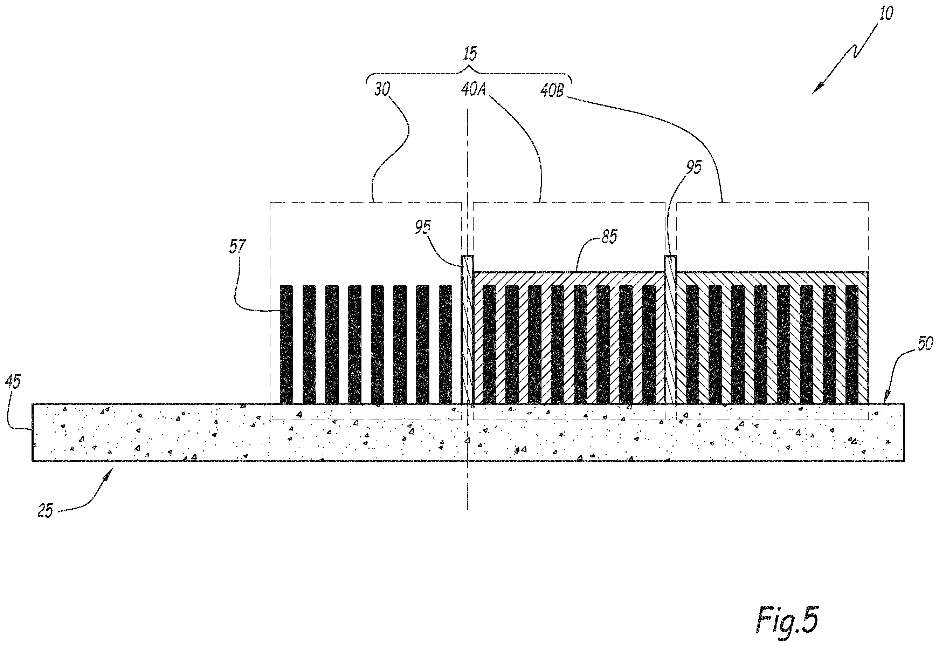

Le deuxième exemple d'écran d'affichage 10 est illustré dans la figure 5.

Chaque dispositif émetteur 15 comprend au moins deux troisièmes émetteurs de lumière 40A, 40B et un premier émetteur de lumière 30. Le dispositif émetteur 15 ne comprend pas de deuxième émetteur de lumière 35.

Il convient de remarquer que des modes de réalisation du deuxième exemple dans lesquels le dispositif émetteur 15 ne comprend pas de premier émetteur de lumière 30 peuvent également être envisagés.

Chaque première structure semi-conductrice et chaque troisième structure semi-conductrice du deuxième exemple de dispositif émetteur 15 sont, par exemple, une structure bidimensionnelle. Toutefois, des modes de réalisation dans lesquels une ou plusieurs des première et troisième structures semi-conductrices comprennent une structure tridimensionnelle parmi un ensemble de structures tridimensionnelles 57 peuvent être envisagés. Dans le mode de réalisation illustré dans la figure 5, chaque structure semi-conductrice comprend un ensemble respectif de structures tridimensionnelles 57.

Dans un mode de réalisation, les première et troisième structures semi-conductrices sont identiques l'une à l'autre.

Le premier rayonnement émis par le premier émetteur de lumière 30 correspond, par exemple, à une lumière bleue.

Comme c'est le cas pour le premier exemple, les convertisseurs de rayonnement 80 des troisièmes émetteurs de lumière 40A et 40B sont fabriqués, respectivement, en noyant des particules dans une masse de résine 85, et par greffage.

Le troisième rayonnement émis par chaque troisième émetteur de lumière 40A, 40B est choisi parmi une lumière verte et une lumière rouge.

Dans un mode de réalisation, la longueur d'onde moyenne du troisième rayonnement émis par le troisième émetteur de lumière 40A dont le convertisseur de rayonnement 80 est fabriqué par greffage est strictement inférieure à la longueur d'onde moyenne du troisième rayonnement émis par le troisième émetteur de lumière 40B dont le convertisseur de rayonnement 80 comprend un ensemble de particules P noyées dans une masse de résine 85. Par exemple, le troisième rayonnement émis par le troisième émetteur de lumière 40B correspond à une lumière verte et le troisième rayonnement émis par le troisième émetteur de lumière 40A correspond à une lumière rouge, ou inversement.

Le dispositif émetteur 15 du deuxième exemple d'écran d'affichage 10 est fabriqué en faisant appel au procédé détaillé dans la figure 3, aucune deuxième structure semi-conductrice n'étant fabriquée au cours de l'étape de fabrication 100.

Le deuxième exemple n'exige pas qu'au moins deux des émetteurs de lumière émettant différents rayonnements soient dépourvus de convertisseur de rayonnement. Ce deuxième exemple est par conséquent plus facile à fabriquer que le premier exemple. En particulier, toutes les structures semi-conductrices peuvent être identiques, seuls les convertisseurs de rayonnement 80 étant différents ou absents d'un émetteur de lumière 30, 40A, 40B à un autre.

Si le troisième émetteur de lumière 40B dont le convertisseur de rayonnement 80 comprend des particules P fixées par greffage est configuré pour émettre un troisième rayonnement présentant une longueur d'onde moyenne inférieure à celle du troisième rayonnement émis par l'autre troisième émetteur de lumière 40A, l'efficacité d'émission du troisième rayonnement peut être relativement élevée malgré l'efficacité de conversion relativement faible des matériaux de conversion qui sont adaptés pour émettre des rayonnements présentant des longueurs d'onde moyennes plus courtes. C'est notamment le cas si la longueur d'onde moyenne du troisième rayonnement émis par le troisième émetteur de lumière 40B correspond à un rayonnement vert, étant donné que les matériaux utilisés pour convertir le rayonnement en une lumière verte sont généralement moins efficaces que ceux convertissant le rayonnement en une lumière rouge.

Cela découle de la très haute densité de surface des particules P pouvant être obtenue par greffage.

Grâce aux différentes techniques de placement des convertisseurs 80 sur chaque troisième émetteur de lumière 40A et 40B, la précision de positionnement des particules P est très élevée, tel que cela a été décrit en référence au premier exemple, et le risque de mélange des convertisseurs est réduit. La régulation de longueurs d'onde de chaque émetteur de lumière 30, 40A, 40B est ainsi améliorée.

### TROISIÈME EXEMPLE DE DISPOSITIF ÉMETTEUR COMPRENANT AU MOINS TROIS ÉMETTEURS DE LUMIÈRE CONVERTIS

Un troisième exemple d'écran d'affichage 10 est à présent décrit. Tous les éléments identiques à ceux du deuxième exemple ne sont pas décrits à nouveau. Seules les différences sont détaillées.

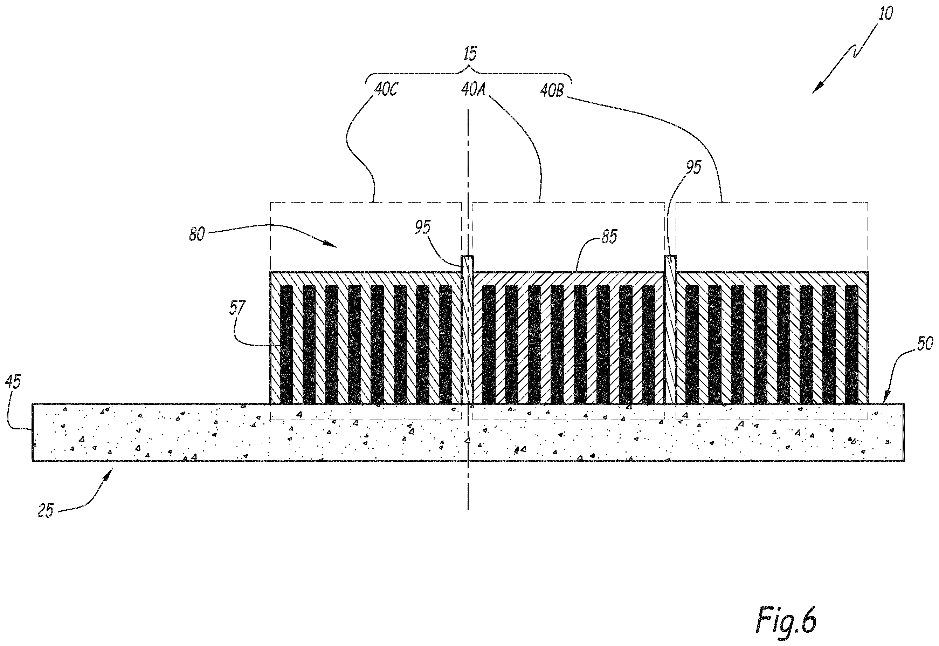

Le troisième exemple d'écran d'affichage 10 est illustré dans la figure 6.

Chaque dispositif émetteur 15 du troisième exemple comprend au moins trois troisièmes émetteurs de lumière 40A, 40B et 40C.

Chaque dispositif émetteur 15 est dépourvu d'un premier émetteur de lumière ou d'un deuxième émetteur de lumière 30, 35. En d'autres termes, chaque dispositif émetteur 15 ne contient aucun émetteur de lumière 30, 35 dépourvu de convertisseur de rayonnement 80.

Le troisième rayonnement émis par chaque troisième émetteur de lumière 40A, 40B et 40C est choisi parmi une lumière bleue, une lumière verte et une lumière rouge.

Dans un mode de réalisation, le troisième émetteur de lumière 40A émettant une lumière rouge comprend un convertisseur de rayonnement constitué au moins partiellement de particules P noyées dans une résine photosensible, tandis que le troisième émetteur de lumière 40B émettant une lumière bleue comprend un convertisseur de rayonnement constitué au moins partiellement de particules P fixées par greffage.

Le convertisseur de rayonnement du troisième émetteur de lumière 40C est choisi parmi un convertisseur de rayonnement constitué au moins partiellement de particules P noyées dans une résine photosensible et un convertisseur de rayonnement constitué au moins partiellement de particules P fixées par greffage.

Chaque quatrième rayonnement est, par exemple, une lumière ultraviolette. Des modes de réalisation dans lesquels le quatrième rayonnement de certains ou de tous les émetteurs 30, 35, 40A, 40B, 40C est une lumière bleue peuvent être envisagés.

L'émission de certaines structures semi-conductrices dans la gamme ultraviolette est plus efficace que l'émission dans la gamme visible. L'efficacité globale du dispositif émetteur 15 est par conséquent améliorée.

Dans les deuxième et troisième exemples susmentionnés, les propriétés qui varient d'un troisième émetteur de lumière 40A, 40B, 40C à un autre sont les propriétés des convertisseurs de rayonnement 80 respectifs, notamment le type de technique utilisé pour fixer les particules P à une surface. Cependant, il apparaîtra ci-dessous que les propriétés des troisièmes structures semi-conductrices peuvent également être modifiées, tout en utilisant des convertisseurs de rayonnement 80 identiques pour chaque troisième émetteur de lumière 40A, 40B, 40C.

### QUATRIÈME EXEMPLE DE DISPOSITIF ÉMETTEUR NE FAISANT PAS PARTIE DE L'INVENTION, COMPRENANT DEUX ÉMETTEURS DE LUMIÈRE CONVERTIS EXCITÉS EN UTILISANT DIFFÉRENTES LONGUEURS D'ONDE.

Un quatrième exemple d'écran d'affichage 10 est à présent décrit. Tous les éléments identiques à ceux du deuxième exemple ne sont pas décrits à nouveau. Seules les différences sont détaillées.

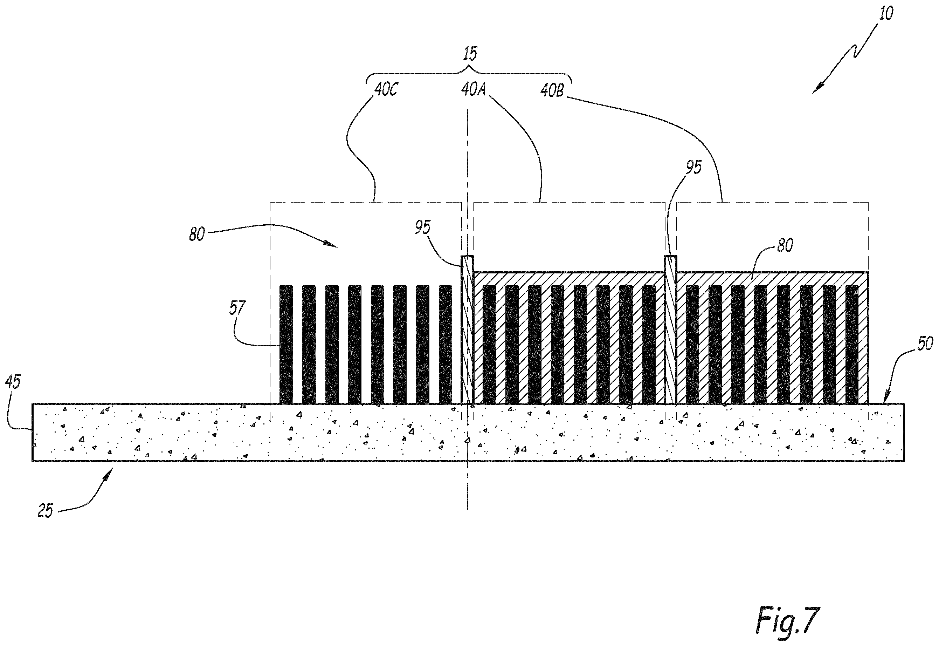

Le quatrième exemple d'écran d'affichage 10 est illustré dans la figure 7.

Chaque dispositif émetteur 15 comprend au moins deux troisièmes émetteurs de lumière 40A, 40B. Par exemple, le dispositif émetteur 15 comprend deux troisièmes émetteurs de lumière 40A, 40B et un premier émetteur de lumière 30. En variante, le dispositif émetteur 15 peut également comprendre un deuxième émetteur de lumière 35.

Les troisièmes structures semi-conductrices de chaque troisième émetteur de lumière 40A, 40B sont mutuellement différentes. En particulier, les quatrièmes rayonnements émis par les troisièmes structures semi-conductrices des deux émetteurs de lumière 40A, 40B sont mutuellement différents. Par exemple, la troisième structure semi-conductrice de l'émetteur de lumière 40A est configurée pour émettre un quatrième rayonnement R1 et la troisième structure semi-conductrice de l'émetteur de lumière 40B est configurée pour émettre un quatrième rayonnement R2 différent du quatrième rayonnement R1.

En particulier, les longueurs d'onde moyennes des quatrièmes rayonnements R1 et R2 sont mutuellement différentes. Une différence de longueurs d'onde entre les rayonnements moyens des quatrièmes rayonnements R1 et R2 est, par exemple, supérieure ou égale à 40 nm.

Dans un mode de réalisation ne faisant pas partie de l'invention, le quatrième rayonnement R1 est un rayonnement bleu et le quatrième rayonnement R2 est un rayonnement ultraviolet.

Les convertisseurs de rayonnement 80 des deux troisièmes émetteurs de lumière 40A, 40B sont mutuellement identiques.

En particulier, chaque convertisseur de rayonnement 80 comprend un ensemble de particules P.

Dans un mode de réalisation ne faisant pas partie de l'invention, un unique convertisseur de rayonnement 80 est utilisé pour les deux troisièmes émetteurs de lumière 40A, 40B. Par exemple, l'unique convertisseur de rayonnement 80 recouvre les deux troisièmes structures semi-conductrices, tel que cela est illustré dans la figure 7.

Les particules P sont, par exemple, soit fixées à une surface de chaque troisième émetteur de lumière 40A, 40B par une unique couche de greffage 83, soit noyées dans une unique masse de résine photosensible 85.

L'ensemble de particules P correspond à un mélange comprenant un ensemble de premières particules P1 et un ensemble de deuxièmes particules P2.

Chaque première particule P1 est configurée pour convertir le quatrième rayonnement R1 émis par la troisième structure semi-conductrice du troisième émetteur de lumière 40A en le troisième rayonnement correspondant.

Chaque deuxième particule P2 est configurée pour convertir le quatrième rayonnement R2 émis par la troisième structure semi-conductrice du troisième émetteur de lumière 40B en le troisième rayonnement correspondant.

Les premières particules P1 sont transparentes pour le troisième rayonnement émis par les deuxièmes particules P2, et les deuxièmes particules P2 sont transparentes pour le troisième rayonnement émis par les premières particules P1.

Au moins l'une parmi la première particule P1 et la deuxième particule P2 est transparente pour l'un des quatrièmes rayonnements R1 et R2. Dans un mode de réalisation, chaque première particule P1 est transparente pour le quatrième rayonnement R2 du troisième émetteur de lumière 40B et chaque deuxième particule P2 est transparente pour le quatrième rayonnement R1 du troisième émetteur de lumière 40A.

En variante, chaque première particule P1 est configurée pour convertir les deux quatrièmes rayonnements R1 et R2 en le troisième rayonnement correspondant au troisième émetteur de lumière 40A, ou chaque deuxième particule P2 est configurée pour convertir les deux quatrièmes rayonnements R1 et R2 en le troisième rayonnement correspondant au troisième émetteur de lumière 40B.

Les particules P1 et P2 peuvent différer par leur composition et/ou leur taille.

Par exemple, les particules P1 et P2 sont constituées d'un même matériau, par exemple un matériau semi-conducteur, mais sont dopées avec différents éléments. Dans un mode de réalisation, les particules P1, P2 sont constituées de ZnSe, les premières particules P1 étant dopées au manganèse, Mn, de façon à émettre un troisième rayonnement rouge et les deuxièmes particules P2 étant dopées au cuivre, Cu, de façon à émettre un troisième rayonnement vert.

Dans certains modes de réalisation ne faisant pas partie de l'invention, les particules P1, P2 sont constituées de différents matériaux. Par exemple, les premières particules P1 sont constituées de ZnSe, dopé au manganèse, Mn, tandis que les deuxièmes particules P2 sont constituées d'InP.

Dans d'autres modes de réalisation ne faisant pas partie de l'invention, les particules P1, P2 sont constituées d'un même matériau semi-conducteur, mais la taille des particules P1 et P2 diffère de façon à obtenir un confinement quantique différent, et par conséquent des propriétés distinctes d'émission/absorption de rayonnement. Par exemple, les particules P1 et P2 sont constituées chacune de ZnSe, dopé Mn.

Il convient de remarquer que, bien que le quatrième exemple soit détaillé ci-dessus dans le cas de deux troisièmes émetteurs de lumière 40A, 40B dont le convertisseur de rayonnement 80 comprend un mélange de deux types de particules P1, P2, d'autres modes de réalisation ne faisant pas partie de l'invention, comprenant au moins trois troisièmes émetteurs de lumière 40A, 40B, 40C et un convertisseur de rayonnement 80 comprenant un mélange d'au moins trois types de particules peuvent également être envisagés.

Le procédé de fabrication du quatrième exemple de dispositif émetteur sera à présent décrit.

Les étapes identiques à celles du procédé de fabrication d'un dispositif émetteur de la figure 3 ne sont pas décrites à nouveau. Seules les différences sont mises en évidence.

Au cours de l'étape de fabrication 100, les troisièmes couches semi-conductrices de chaque troisième émetteur de lumière 40A, 40B sont différentes l'une de l'autre, de façon à être aptes à émettre différents rayonnements R1, R2.

Par exemple, le diamètre et/ou la période spatiale, des structures tridimensionnelles 57 diffèrent entre les deux structures semi-conductrices, de sorte que l'étape de dépôt 130 donne lieu à des couches semi-conductrices différentes.

Au cours de l'étape de dépôt 110, un mélange de premières particules P1 et de deuxièmes particules P2 est déposé. En particulier, le mélange est déposé simultanément sur les surfaces correspondantes du troisième émetteur de lumière 40A et du troisième émetteur de lumière 40B.

Par exemple, l'étape de dépôt 110 comprend le dépôt simultané d'une unique masse de résine 85 sur les surfaces des deux troisièmes émetteurs de lumière 40A et 40B, par exemple sur les surfaces des deux troisièmes structures semi-conductrices.

En variante, l'étape de dépôt 110 comprend l'étape de fonctionnalisation 130 et l'étape de dépôt d'un convertisseur 170.

Au cours de l'étape de fonctionnalisation 130, la couche de greffage 83 est déposée dans les surfaces correspondantes des deux troisièmes émetteurs de lumière 40A et 40B.

Par exemple, une couche de greffage 83 de molécules M est déposée sur les deux surfaces.

Au cours de l'étape de dépôt du convertisseur 170, le mélange des particules P1, P2 est déposé sur la couche de greffage 83. En particulier, le mélange des particules P1, P2 est déposé de manière à être simultanément fixé aux surfaces des deux troisièmes émetteurs de lumière 40A et 40B.

En utilisant un mélange de particules P1, P2 et des quatrièmes rayonnements R1, R2 différents, le risque de mélange des convertisseurs est éliminé. La résolution spatiale du dispositif émetteur 15 n'est limitée que par la taille latérale de chaque émetteur de lumière 40A, 40B, ou par la précision avec laquelle le filtre de rayonnement est délimité.

Ceci est particulièrement vrai si chaque type de particules P1, P2 est transparent pour un quatrième rayonnement R1, R2 respectif, étant donné que seul un type de particules est ensuite activé par chaque quatrième rayonnement, ce qui se traduit par une bonne gestion des couleurs de chaque troisième émission.

Toutefois, si un type de particules P1, P2 est configuré pour absorber les deux quatrièmes rayonnements R1, R2, il en résulte un dispositif émetteur dans lequel le quatrième rayonnement R1, R2 d'un émetteur de lumière 40A, 40B peut être converti en un troisième rayonnement par un type de particules P1, P2, tandis que le quatrième rayonnement R1, R2 de l'autre émetteur de lumière 40A, 40B peut être converti en un troisième rayonnement par les deux types de particules P1, P2. Ainsi, le troisième rayonnement correspondant à l'autre émetteur de lumière 40A, 40B peut présenter un spectre optique plus large, par exemple une lumière blanche.

Dans un quatrième exemple, les filtres de rayonnement utilisés pour chaque émetteur de lumière 40A, 40B sont différents.

Notamment, le filtre de rayonnement du troisième émetteur de lumière 40A est configuré pour être traversé par le troisième rayonnement du troisième émetteur de lumière 40A (émis par les premières particules P1) et à former une barrière pour le quatrième rayonnement du troisième émetteur de lumière 40B (émis par les deuxièmes particules P2). Le filtre de rayonnement du troisième émetteur de lumière 40B est configuré pour être traversé par le troisième rayonnement du troisième émetteur de lumière 40B (émis par les deuxièmes particules P2) et à former une barrière pour le quatrième rayonnement du troisième émetteur de lumière 40A (émis par les premières particules P1). Ce mode de réalisation ne faisant pas partie de l'invention, permet par conséquent d'utiliser des particules P1, P2 qui ne sont pas transparentes pour le quatrième rayonnement R1, R2, que les particules ne sont pas configurées pour convertir, étant donné que tout troisième rayonnement indésirable résultant de la conversion du rayonnement R1 par les particules P2, ou de la conversion du rayonnement R2 par les particules P1, est filtré par le filtre.

Étant donné qu'il est facile de concevoir un filtre de rayonnement avec une précision supérieure à la précision de dépôt des convertisseurs de rayonnement 80, ce mode de réalisation offre une résolution spatiale supérieure à celle des dispositifs émetteurs 15 existants, tout en étant compatible avec une plus grande gamme de particules P1, P2.

Dans un exemple spécifique de ce mode de réalisation ne faisant pas partie de l'invention, les quatrièmes rayonnements R1 et R2 sont identiques, et seuls les filtres de rayonnement sont différents pour les troisièmes émetteurs de lumière 40A et 40B.

L'invention correspond aux revendications qui suivent.

### GLOSSAIRE

### DOPAGE

Le dopage se définit comme la présence, dans un matériau, d'impuretés apportant des porteurs de charges libres. Les impuretés sont, par exemple, des atomes d'un élément qui n'est pas naturellement présent dans le matériau.

Lorsque les impuretés augmentent la densité volumique de trous dans le matériel, par rapport à du matériel non dopé, le dopage est de type p. Par exemple, une couche de nitrure de gallium, GaN, est dopée p en ajoutant des atomes de magnésium (Mg).

Lorsque les impuretés augmentent la densité volumique d'électrons libres dans le matériau, par rapport au matériau non dopé, le dopage est de type n. Par exemple, une couche de nitrure de gallium, GaN, est dopée n en ajoutant des atomes de silicium (Si).

### STRUCTURE LED

Une structure LED est une structure semi-conductrice comprenant plusieurs zones semi-conductrices formant une jonction P-N et configurée pour émettre de la lumière lorsqu'un courant électrique circule à travers les différentes zones semi-conductrices.

Une structure bidimensionnelle comprenant une couche dopée n, une couche dopée p et au moins une couche émettrice est un exemple de structure LED. Dans ce cas, chaque couche émettrice est interposée, le long de la direction normale D, entre la couche dopée n et la couche dopée p.

Dans un mode de réalisation, chaque couche émettrice présente une valeur de bande interdite strictement inférieure à la valeur de bande interdite de la couche dopée n et strictement inférieure à la valeur de bande interdite de la couche dopée p. Par exemple, la couche dopée n et la couche dopée p sont des couches de GaN, et chaque couche émettrice est une couche d'InGaN.

La couche émettrice est, par exemple, non dopée. Dans d'autres modes de réalisation, la couche émettrice est dopée.

Un puits quantique constitue un exemple spécifique de couche émettrice présentant une valeur de bande interdite inférieure aux valeurs de bande interdite des couches dopées n et p.

### PUITS QUANTIQUE

Un puits quantique est une structure dans laquelle un confinement quantique se produit, dans une direction, pour au moins un type de porteurs de charges. Les effets du confinement quantique se produisent lorsque la dimension de la structure le long de cette direction devient comparable à ou plus petite que la longueur d'onde de De Broglie des porteurs, lesquels sont généralement des électrons et/ou à des trous, conduisant à des niveaux d'énergie appelés « sous-bandes d'énergie ».

Dans un tel puits quantique, les porteurs ne peuvent présenter que des valeurs d'énergie discrètes mais sont généralement aptes à se déplacer à l'intérieur d'un plan perpendiculaire à la direction dans laquelle le confinement se produit. Les valeurs d'énergie disponibles pour les porteurs, également appelées « niveaux d'énergie », augmentent lorsque les dimensions du puits quantique diminuent le long de la direction dans laquelle le confinement se produit.

En mécanique quantique, la « longueur d'onde de De Broglie » est la longueur d'onde d'une particule lorsque la particule est considérée comme une onde. La longueur d'onde de De Broglie des électrons est également appelée « longueur d'onde électronique ». La longueur d'onde de De Broglie d'un porteur de charge dépend du matériau dont est constitué le puits quantique.

Une couche émettrice dont l'épaisseur est strictement inférieure au produit de la longueur d'onde électronique des électrons dans le matériau semi-conducteur dont la couche émettrice est constituée et de cinq est un exemple de puits quantique.

Un autre exemple de puits quantique est une couche émettrice dont l'épaisseur est strictement inférieure au produit de la longueur d'onde de De Broglie d'excitons dans le matériau semi-conducteur dont la couche émettrice est constituée et de cinq. Un exciton est une quasi-particule comprenant un électron et un trou.

En particulier, un puits quantique présente souvent une épaisseur comprise entre 1 nm et 200 nm.

### BOITE QUANTIQUE

Une boîte quantique est une structure dans laquelle un confinement quantique se produit dans les trois dimensions spatiales.

Pour donner un ordre de valeur, une particule P présentant une dimension maximale comprise entre 1 nm et 1 µm, et constituée d'un matériau de conversion semi-conducteur, constitue un exemple de boîte quantique.

### MATÉRIAU SEMI-CONDUCTEUR

L'expression « valeur de bande interdite » doit être comprise comme étant la valeur de la bande interdite entre la bande de valence et la bande de conduction du matériau.

La valeur de bande interdite est, par exemple, mesurée en électrons-volts (eV).

La bande de valence est définie comme étant, parmi les bandes d'énergie qui sont autorisées pour les électrons dans le matériau, la bande qui présente l'énergie la plus élevée tout en étant complètement remplie à une température inférieure ou égale à 20 Kelvin (K).

Un premier niveau d'énergie est défini pour chaque bande de valence. Le premier niveau d'énergie est le niveau d'énergie le plus élevé de la bande de valence.

La bande de conduction est définie comme étant, parmi les bandes d'énergie qui sont autorisées pour les électrons dans le matériau, la bande qui présente l'énergie la plus faible tout en n'étant pas complètement remplie à une température inférieure ou égale à 20 K.

Un deuxième niveau d'énergie est défini pour chaque bande de conduction. Le deuxième niveau d'énergie est le niveau d'énergie le plus élevé de la bande de conduction.

Ainsi, chaque valeur de bande interdite est mesurée entre le premier niveau d'énergie et le deuxième niveau d'énergie du matériau.

Un matériau semi-conducteur est un matériau présentant une valeur de bande interdite strictement supérieure à zéro et inférieure ou égale à 6,5 eV.

Un semi-conducteur à bande interdite directe constitue un exemple de matériau semi-conducteur. Un matériau est considéré comme présentant une « bande interdite directe » lorsque le minimum de la bande de conduction et le maximum de la bande de valence correspondent à une même valeur de quantité de mouvement de porteurs de charge. Un matériau est considéré comme présentant une « bande interdite indirecte » lorsque le minimum de la bande de conduction et le maximum de la bande de valence correspondent à différentes valeurs de quantité de mouvement de porteurs de charge.

### STRUCTURE TRIDIMENSIONNELLE

Une structure tridimensionnelle est une structure qui s'étend le long d'une direction principale. La structure tridimensionnelle présente une longueur mesurée le long de la direction principale. La structure tridimensionnelle présente également une dimension latérale maximale mesurée le long d'une direction latérale perpendiculaire à la direction principale, la direction latérale étant la direction perpendiculaire à la direction principale le long de laquelle la dimension de la structure est la plus grande.

La dimension latérale maximale est, par exemple, inférieure ou égale à 10 micromètres (µm), et la longueur est supérieure ou égale à la dimension latérale maximale. La dimension latérale maximale est avantageusement inférieure ou égale à 2,5 µm.

La dimension latérale maximale est, notamment, supérieure ou égale à 10 nm.

Dans des modes de réalisation spécifiques, la longueur est supérieure ou égale à deux fois la dimension latérale maximale, par exemple elle est supérieure ou égale à cinq fois la dimension latérale maximale.

La direction principale est, par exemple, la direction normale D. Dans ce cas, la longueur de la structure tridimensionnelle est appelée « hauteur » et la dimension maximale de la structure tridimensionnelle, dans un plan perpendiculaire à la direction normale D, est inférieure ou égale à 10 µm.

La dimension maximale de la structure tridimensionnelle, dans un plan perpendiculaire à la direction normale D, est souvent appelée « diamètre » quelle que soit la forme de la section transversale de la structure tridimensionnelle.

Par exemple, chaque structure tridimensionnelle est un microfil. Un microfil est une structure tridimensionnelle cylindrique.

Dans un mode de réalisation spécifique, le microfil est un cylindre s'étendant le long de la direction normale D. Par exemple, le microfil est un cylindre à base circulaire. Dans ce cas, le diamètre de la base du cylindre est inférieur ou égal à la moitié de la longueur du microfil.

Un microfil dont la dimension latérale maximale est inférieure à 1 µm est appelé un « nanofil ».

Une pyramide s'étendant le long de la direction normale D à partir du substrat 25 constitue un autre exemple de structure tridimensionnelle.

Un cône s'étendant le long de la direction normale D constitue un autre exemple de structure tridimensionnelle.

Un cône tronqué ou une pyramide tronquée s'étendant le long de la direction normale D constitue encore un autre exemple de structure tridimensionnelle.

## Revendications

1. Dispositif émetteur (15) comprenant :
- un premier émetteur de lumière (40A), le premier émetteur de lumière (40A) étant apte à émettre un premier rayonnement ; et
- un deuxième émetteur de lumière (40B), le deuxième émetteur de lumière (40B) étant apte à émettre un deuxième rayonnement, le deuxième rayonnement étant différent du premier rayonnement ;
le premier émetteur de lumière (40A) comprenant une première structure semi-conductrice et un premier convertisseur de rayonnement (80), le deuxième émetteur de lumière (40B) comprenant une deuxième structure semi-conductrice et un deuxième convertisseur de rayonnement (80), chaque structure semi-conductrice comprenant une couche semi-conductrice apte à émettre un troisième rayonnement différent du premier rayonnement et du deuxième rayonnement, chaque convertisseur de rayonnement (80) comprenant un ensemble de particules (P), chaque particule (P) étant propre à convertir le troisième rayonnement en le premier rayonnement ou le deuxième rayonnement émis par l'émetteur de lumière correspondant (40A, 40B) ;
les particules (P) du premier convertisseur de rayonnement (80) étant fixées par une masse de résine photosensible à une surface du premier émetteur de lumière (40A), telle qu'une surface de la première structure semi-conductrice, et **caractérisé en ce que** les particules (P) du deuxième convertisseur de rayonnement (80) sont fixées par greffage à une surface du deuxième émetteur de lumière (40B), telle qu'une surface de la deuxième structure semi-conductrice.

2. Dispositif émetteur selon la revendication 1, dans lequel le deuxième convertisseur de rayonnement (80) comprend un empilement d'au moins une couche (82) de particules (P) et d'au moins une couche de greffage (83) de molécules organiques (M), la couche (82) de particules (P) étant fixée à une surface du deuxième émetteur de lumière (40B) par la couche de greffage (83).

3. Dispositif émetteur selon la revendication 1 ou 2, dans lequel une longueur d'onde moyenne du deuxième rayonnement est strictement inférieure à une longueur d'onde moyenne du premier rayonnement.

4. Dispositif émetteur selon l'une quelconque des revendications 1 à 3, comprenant en outre au moins un troisième émetteur (30), le troisième émetteur de lumière (30) étant apte à émettre un quatrième rayonnement, le quatrième rayonnement étant différent du premier rayonnement et du deuxième rayonnement, le troisième émetteur de lumière (30) comprenant au moins une troisième structure semi-conductrice, la troisième structure semi-conductrice comprenant une troisième couche semi-conductrice, la troisième couche semi-conductrice étant apte à émettre le quatrième rayonnement.

5. Dispositif émetteur selon l'une quelconque des revendications 1 à 4, comprenant en outre au moins un quatrième émetteur de lumière (40C), le quatrième émetteur de lumière (40C) étant apte à émettre un cinquième rayonnement, le cinquième rayonnement étant différent du premier rayonnement et du deuxième rayonnement ;
le quatrième émetteur de lumière (40C) comprenant une quatrième structure semi-conductrice (57) et un quatrième convertisseur de rayonnement (80), la quatrième structure semi-conductrice (57) comprenant une couche semi-conductrice apte à émettre un troisième rayonnement différent du cinquième rayonnement, le convertisseur de rayonnement (80) du quatrième émetteur de lumière (40C) comprenant un ensemble de particules (P), chaque particule (P) étant configurée pour convertir le troisième rayonnement en le cinquième rayonnement.

6. Dispositif émetteur selon l'une quelconque des revendications 1 à 5, comprenant en outre au moins une paroi (95) propre à empêcher qu'un rayonnement émis par un émetteur de lumière (30, 35, 40A, 40B, 40C) d'atteindre un autre émetteur de lumière (30, 35, 40A, 40B, 40C).

7. Procédé de fabrication d'un dispositif émetteur (10) comprenant
- un premier émetteur de lumière (40A), le premier émetteur de lumière (40A) étant apte à émettre un premier rayonnement ; et
- un deuxième émetteur de lumière (40B), le deuxième émetteur de lumière (40B) étant apte à émettre un deuxième rayonnement, le deuxième rayonnement étant différent du premier rayonnement ;
le procédé comprenant des étapes de :
- fabrication (100) d'au moins une première structure semi-conductrice et d'au moins une deuxième structure semi-conductrice, la première structure semi-conductrice comprenant une première couche semi-conductrice, la deuxième structure semi-conductrice comprenant une deuxième couche semi-conductrice, chaque première et deuxième couche semi-conductrice étant propre à émettre un troisième rayonnement différent du premier rayonnement et du deuxième rayonnement ;
- positionnement (150), sur une surface du premier émetteur de lumière (40A), d'une masse de résine photosensible comprenant des particules (P) propres à convertir le troisième rayonnement de la première couche semi-conductrice en le premier rayonnement ; le procédé étant **caractérisé en ce qu'**il comprend les étapes de:
- dépôt (160), sur une surface du deuxième émetteur de lumière (40B), d'une couche de greffage ; et
- dépôt, sur la couche de greffage, d'une couche de particules (P) propre à convertir le troisième rayonnement de la deuxième couche semi-conductrice en le deuxième rayonnement, chaque particule (P) étant fixée à la surface du deuxième émetteur de lumière (40B) par la couche de greffage.

8. Écran d'affichage (10) comprenant au moins un dispositif émetteur selon l'une quelconque des revendications 1 à 6.

## Patentansprüche

1. Emittervorrichtung (15), umfassend:
- einen ersten Lichtemitter (40A), wobei der erste Lichtemitter (40A) geeignet ist, um eine erste Strahlung zu emittieren; und
- einen zweiten Lichtemitter (40B), wobei der zweite Lichtemitter (40B) geeignet ist, um eine zweite Strahlung zu emittieren, wobei sich die zweite Strahlung von der ersten Strahlung unterscheidet;
der erste Lichtemitter (40A) umfassend eine erste halbleitende Struktur und einen ersten Strahlungswandler (80) umfasst, der zweite Lichtemitter (40B) umfassend eine zweite Halbleiterstruktur und einen zweiten Strahlungswandler (80), jede Halbleiterstruktur umfassend eine Halbleiterschicht, die in der Lage ist, eine dritte Strahlung zu erzeugen, die sich von der ersten Strahlung und der zweiten Strahlung unterscheidet, jeder Strahlungswandler (80) umfassend eine Partikelanordnung (P), wobei jedes Partikel (P) geeignet ist, um die dritte Strahlung in die erste Strahlung oder die zweite Strahlung umzuwandeln, die von dem entsprechenden Lichtemitter (40A, 40B) emittiert wird;
wobei die Partikel (P) des ersten Strahlungswandlers (80) durch eine lichtempfindliche Harzmasse an einer Oberfläche des ersten Lichtemitters (40A), wie beispielsweise einer Oberfläche der ersten Halbleiterstruktur, befestigt sind, und **dadurch gekennzeichnet, dass** die Partikel (P) des zweiten Strahlungswandlers (80) durch Pfropfen an einer Oberfläche des zweiten Lichtemitters (40B), wie beispielsweise einer Oberfläche der zweiten Halbleiterstruktur, befestigt sind.

2. Emittervorrichtung nach Anspruch 1, wobei der zweite Strahlungswandler (80) einen Stapel aus mindestens einer Schicht (82) von Partikeln (P) und mindestens einer Pfropfschicht (83) von organischen Molekülen (M) umfasst, wobei die Schicht (82) von Partikeln (P) durch die Pfropfschicht (83) an einer Oberfläche des zweiten Lichtemitters (40B) befestigt ist.

3. Emittervorrichtung nach Anspruch 1 oder 2, wobei eine mittlere Wellenlänge der zweiten Strahlung strikt kleiner ist als eine mittlere Wellenlänge der ersten Strahlung.

4. Emittervorrichtung nach einem der Ansprüche 1 bis 3, ferner umfassend mindestens einen dritten Emitter (30), wobei der dritte Emitter (30) geeignet ist, um eine vierte Strahlung zu emittieren, wobei sich die vierte Strahlung von der ersten Strahlung und der zweiten Strahlung unterscheidet, der dritte Emitter (30) umfassend mindestens eine dritte Halbleiterstruktur, die dritte Halbleiterstruktur umfassend eine dritte Halbleiterschicht, wobei die dritte Halbleiterschicht in der Lage ist, die vierte Strahlung zu emittieren.

5. Emittervorrichtung nach einem der Ansprüche 1 bis 4, ferner umfassend mindestens einen vierten Lichtemitter (40C), wobei der vierte Lichtemitter (40C) geeignet ist, um eine fünfte Strahlung zu emittieren, wobei sich die fünfte Strahlung von der ersten Strahlung und der zweiten Strahlung unterscheidet;
der vierte Lichtemitter (40C) umfassend eine vierte Halbleiterstruktur (57) und einen vierten Strahlungswandler (80), die vierte Halbleiterstruktur (57) umfassend eine Halbleiterschicht, die in der Lage ist, eine dritte Strahlung zu emittieren, die sich von der fünften Strahlung unterscheidet, der Strahlungswandler (80) des vierten Lichtemitters (40C) umfassend eine Anordnung von Partikeln (P), wobei jedes Partikel (P) konfiguriert ist, um die dritte Strahlung in die fünfte Strahlung umzuwandeln.

6. Emittervorrichtung nach einem der Ansprüche 1 bis 5, ferner umfassend mindestens eine Wand (95), die verhindern kann, dass eine von einem Lichtemitter (30, 35, 40A, 40B, 40C) emittierte Strahlung einen anderen Lichtemitter (30, 35, 40A, 40B, 40C) erreicht.

7. Verfahren zur Herstellung einer Emittervorrichtung (10), umfassend
- einen ersten Lichtemitter (40A), wobei der erste Lichtemitter (40A) geeignet ist, um eine erste Strahlung zu emittieren; und
- einen zweiten Lichtemitter (40B), wobei der zweite Lichtemitter (40B) geeignet ist, um eine zweite Strahlung zu emittieren, wobei sich die zweite Strahlung von der ersten Strahlung unterscheidet;
das Verfahren umfassend die folgenden Schritte:
- Herstellen (100) von mindestens einer ersten Halbleiterstruktur und mindestens einer zweiten Halbleiterstruktur, die erste Halbleiterstruktur umfassend eine erste Halbleiterschicht, die zweite Halbleiterstruktur umfassend eine zweite Halbleiterschicht, wobei jede erste und zweite Halbleiterschicht geeignet ist, eine dritte Strahlung zu emittieren, die sich von der ersten Strahlung und der zweiten Strahlung unterscheidet;
- Positionieren (150), auf einer Oberfläche des ersten Lichtemitters (40A), einer lichtempfindlichen Harzmasse, umfassend Partikel (P), die geeignet sind, um die dritte Strahlung von der ersten Halbleiterschicht in die erste Strahlung umzuwandeln; wobei das Verfahren **dadurch gekennzeichnet ist, dass** es die folgenden Schritte umfasst:
- Aufbringen (160), auf eine Oberfläche des zweiten Lichtemitters (40B), einer Pfropfschicht; und
- Aufbringen, auf die Pfropfschicht, einer Schicht von Partikeln (P), die geeignet sind, um die dritte Strahlung der zweiten Halbleiterschicht in die zweite Strahlung umzuwandeln, wobei jedes Partikel (P) durch die Pfropfschicht an der Oberfläche des zweiten Lichtemitters (40B) befestigt ist.

8. Anzeigebildschirm (10), umfassend mindestens eine Emittervorrichtung nach einem der Ansprüche 1 bis 6.

## Claims

1. An emitting device (15) comprising :
- a first light emitter (40A), the first light emitter (40A) being adapted to emit a first radiation, and
- a second light emitter (40B), the second light emitter (40B) being adapted to emit a second radiation, the second radiation being different from the first radiation,
the first light emitter (40A) comprising a first semiconducting structure and a first radiation converter (80), the second light emitter (40B) comprising a second semiconducting structure and a second radiation converter (80), each semiconducting structure comprising a semiconducting layer adapted to emit a third radiation different from the first radiation and the second radiation, each radiation converter (80) comprising a set of particles (P), each particle (P) being able to convert the third radiation into the first or second radiation emitted by the corresponding light emitter (40A, 40B),
the particles (P) of the first radiation converter (80) being attached by a bulk of photosensitive resin to a surface of the first light emitter (40A), such as a surface of the first semiconducting structure, and **characterized in that** the particles (P) of the second radiation converter (80) are attached by grafting to a surface of the second light emitter (40B), such as a surface of the second semiconducting structure.

2. The emitting device according to claim 1, wherein the second radiation converter (80) comprises a stack of at least one layer (82) of particles (P) and at least one grafting layer (83) of organic molecules (M), the layer (82) of particles (P) being attached to a surface of the second light emitter (40B) by the grafting layer (83).

3. The emitting device according to claim 1 or 2, wherein a mean wavelength of the second radiation is strictly inferior to a mean wavelength of the first radiation.

4. The emitting device according to any one of claims 1 to 3, further comprising at least one third emitter (30), the third light emitter (30) being adapted to emit a fourth radiation, the fourth radiation being different from the first radiation and the second radiation, the third light emitter (30) comprising at least one third semiconducting structure, the third semiconducting structure comprising a third semiconducting layer, the third semiconducting layer being adapted to emit the fourth radiation.

5. The emitting device according to any one of claims 1 to 4, further comprising at least one fourth light emitter (40C), the fourth light emitter (40C) being adapted to emit a fifth radiation, the fifth radiation being different from the first radiation and the second radiation,
the fourth light emitter (40C) comprising a fourth semiconducting structure (57) and a fourth radiation converter (80), the fourth semiconducting structure (57) comprising a semiconducting layer adapted to emit a third radiation different from the fifth radiation, the radiation converter (80) of the fourth light emitter (40C) comprising a set of particles (P), each particle (P) being able to convert the third radiation into the fifth radiation.

6. The emitting device according to any one of claims 1 to 5, further comprising at least one wall (95) able to prevent a radiation emitted by one light emitter (30, 35, 40A, 40B, 40C) from reaching another light emitter (30, 35, 40A, 40B, 40C).

7. A method for fabricating an emitting device (10) comprising
- a first light emitter (40A), the first light emitter (40A) being adapted to emit a first radiation, and
- a second light emitter (40B), the second light emitter (40B) being adapted to emit a second radiation, the second radiation being different from the first radiation,
the method comprising steps for :
- fabricating (100) at least one first semiconducting structure and at least one second semiconducting structure, the first semiconducting structure comprising a first semiconducting layer, the second semiconducting structure comprising a second semiconducting layer, each first and second semiconducting layer being adapted to emit a third radiation different from the first radiation and the second radiation,
- positioning (150), onto a surface of the first light emitter (40A), a bulk of photosensitive resin comprising particles (P) able to convert the third radiation of the first semiconducting layer into the first radiation,
the method being **characterized in that** it comprises the steps for:
- depositing (160), onto to a surface of the second light emitter (40B), a grafting layer, and
- depositing, onto the grafting layer, a layer of particles (P) able to convert the third radiation of the second semiconducting layer into the second radiation, each particle (P) being attached to the surface of the second light emitter (40B) by the grafting layer.

8. A display screen (10) comprising at least one emitting device according to any one of claims 1 to 6.
